# EUROPÄISCHE PATENTANMELDUNG

(11) **EP 2 682 434 A1**
(43) Veröffentlichungstag der Anmeldung: **08.01.2014**
(21) Anmeldenummer: 12174904.8
(22) Anmeldetag: 04.07.2012
(51) Int. Cl.: C09B 67/00, C09B 45/14, C09B 45/18, C09B 45/22, G02F 1/1335

(54) **Metallazopigmente und daraus hergestellte Pigmentpräparationen**

(71) Anmelder: LANXESS Deutschland GmbH, 50569 Köln (DE)
(72) Erfinder: Borst, Hans-Ulrich, Dr., 50189 Elsdorf (DE); Linke, Frank, 51069 Köln (DE); Füllmann, Heinz-Josef, Dr., 42799 Leichlingen (DE); Michaelis, Stephan, Dr., 51519 Odenthal (DE); Pfuetzenreuter, Dirk, 51399 Burscheid (DE); Endert, Sabine, 42327 Wuppertal (DE)

(57) **Zusammenfassung**

Die neuen Metallazopigmente enthaltend das Addukt aus
a) mindestens zwei Metallazoverbindungen der Formel (I) oder deren tautomeren Formen 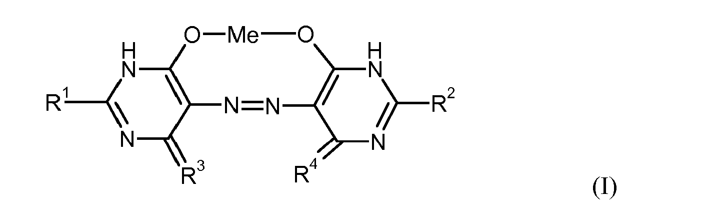 worin die Substituenten die in der Beschreibung angegebene Bedeutung haben,
und
b) mindestens einer Verbindung der Formel (II) 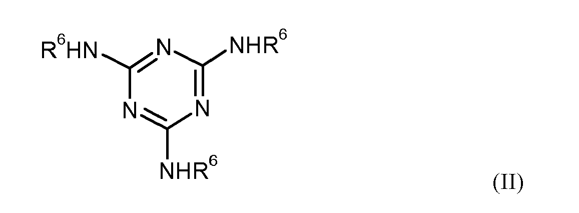 worin
R⁶
die in der Beschreibung angegebene Bedeutung hat,

sind dadurch gekennzeichnet, dass das Metallazopigment im Röntgendiffraktogramm bei einer Gitterkonstanten von d = 10,3 ( ± 0,2) Å ein Signal S₁ mit einer Intensität I₁ aufweist und im Gitterkonstantenbereich von d = 16,05 Å bis d = 11,78 Å kein Signal S₂ aufweist dessen Intensität I₂ im Verhältnis zur Intensität I₁ von Signal S₁, ausgedrückt als Quotient I₂/I₁ der untergrundkorrigierten Intensitäten, den Wert 0,02 überschreitet,
und eigenen sich hervorragend zur Herstellung von Pigmentpräparationen und insbesondere zur Herstellung von Farbfiltern.

## Beschreibung

Die Erfindung betrifft neue Metallazopigmente, Verfahren zu deren Herstellung, Pigmentpräparationen enthaltend diese Metallazopigmente sowie ihre Verwendung, insbesondere zur Herstellung von Farbfiltern, sowie die Farbfilter selbst.

Farbfilter finden heute vornehmlich Anwendung in Flüssigkristallanzeigen, -bildschirmen, Farbauflösungsgeräten und Sensoren. Ein bekanntes Beispiel sind die Flachbildschirme bei Personalcomputern. Es gibt verschiedene Methoden zur Herstellung der Farbfilter, die sich sowohl in der Auftragung der Farben als auch der Erzeugung der Farbelementmuster der Basisfarben rot, grün und blau neben schwarz unterscheiden. Die Applikation bzw. Auftragung der Farben kann z.B. durch Einfärben einer Trägerschicht (z.B. Gelatine) mittels löslichen Farbstoffen oder Pigmenten ("Dye Method", "Dye Dispersion Method"), Siebdruck, Offsetdruck oder Tintenstrahldruck von Pigmentpasten, -präparationen oder -tinten, Elektrodeposition von Photolacken auf Basis von Farbstoffen oder Pigmenten sowie insbesondere mittels der Pigment-Dispersionsmethode, bei der Pigmente verwendet werden, die entweder in einem Polyimidharz ("nicht-photosensitive Polyimidmethode") oder in einem Photolack ("photosensitive Acrylmethode") dispergiert sind, erfolgen. Verbunden mit den genannten Verfahren kommt sowohl der drucktechnisch direkten Erzeugung der Farbelementmuster als auch der indirekten, photolithographischen Erzeugung Bedeutung zu letztere insbesondere bei der o.g. Pigmentdispersionsmethode. Die Technik der Pigment-Dispersionsmethode in Form der "nicht-photosensitiven Polyimidmethode" ist beispielsweise in JP-A-11-217514 (1998) offenbart.

Bei der Pigment-Dispersionsmethode nach dem Photolackverfahren liegen die farbgebenden Pigmente in einem UV-härtbaren Photolack feinverteilt (dispergiert) vor. Der Photolack besteht dabei neben dem Pigment im Allgemeinen aus den Komponenten Bindemittelharz, polymerisierbares Monomer, Photoinitiator sowie gegebenenfalls einem Lösungsmittel. Die Herstellung erfolgt z.B. derart, dass zunächst das Pigment in Form eines Konzentrates in einem Lösungsmittel und gegebenenfalls Bindemittelharz feinteilig dispergiert wird und unmittelbar vor der Applikation zusammen mit dem Monomer und dem Photoinitiator sowie gegebenenfalls weiteren Komponenten eingestellt wird. Der pigmentierte Fotolack wird auf das Substrat, z.B. Glass, gleichmäßig aufgetragen, z.B. mittels dem sogenannten "spin coating"- Verfahren, vorgetrocknet, mittels einer Fotomaske UV belichtet, mittels einer in der Regel anorganisch alkalischen Lösung zu den gewünschten Farbelementmustern entwickelt, die Beschichtung gereinigt und gegebenenfalls nachgehärtet. Dieser Prozess wird für jede Farbe wiederholt, in der Regel also 3 mal für eine Trichromie z.B. in den Farben rot, grün und blau.

Die Vorteile bei der Verwendung von Pigmenten in Verbindung mit der Pigment-Dispersionsmethode liegen in der verbesserten Licht-, Feuchtigkeits- und Temperaturbeständigkeit der Farbfilter im Vergleich zu farbstoff-basierenden Beschichtungssystemen. Demgegenüber sind die Transparenz und Farbreinheit der Beschichtungen auf Basis von Pigmenten, unabhängig vom Beschichtungsverfahren, noch nicht zufriedenstellend. Insbesondere wenn verschiedene Pigmente in Mischung zur Nuancierung auf die gewünschten Farbortwerte im Fotolack eingearbeitet werden, kommt es zu unerwünschten Brillianz- und Transparenzverlusten, so dass als Folge die Anzeigen bzw. Bildschirme (LCD) mit einem erhöhten Energieaufwand betrieben werden müssen.

Aus EP-A-947563 sind spezielle Azopyrazolone für den Einsatz in Farbfiltern beschrieben. Einzelne Pigmente, die nach dem Stand der Technik in Farbfiltern zum Einsatz kommen, sind z.B. in JP-A-11-217514, JP-A-11-209631 offenbart, speziell das Pigment Colour Index Pigment Yellow 150 in JP-A-11-209632. Diese sind jedoch im Hinblick auf die beschriebenen Anforderungen noch zu verbessern.

In EP-A-1 146 087 wird als Gelbkomponente der grünen Farbe ein Metallazopigment beschrieben.

Bevorzugt setzt sich die gelbgrüne Farbkomponente aus dem CI Pigment Green 36 bzw. CI Pigment Green 58 und einem gelben Metallazopigment zusammen. Zur besseren Kombinierbarkeit mit den übrigen Farbtönen ist eine möglichst chromatische und transparente gelbgrüne Farbkomponente vorteilhaft. Dafür muss das gelbe Pigment möglichst chromatisch und transparent sein. Das gelbe Pigment sollte gleichzeitig nicht selber grünstichig sein, um beispielsweise das als Einzelkomponente viel zu grüne Pigment Green 36 besser abmischen zu können. Eine kleine Verschiebung im Farbton des gelben Pigmentes Richtung 'Rot' bzw. eine Erhöhung des Chroma bedeuten eine dramatische Verbesserung dieses gelben Pigmentes als Nuancierkomponente für z.B. ein Pigment Green 36 oder 58. Im optimalen Fall sollte zudem die Addition der jeweiligen drei Farbfilter (Rot, Grün, Blau) eine vollständige Lichtabsorption ergeben.

In EP-A 1 591 489 wurden bereits neue, hinsichtlich der Brillanz des Farbtons verbesserte, Pigmentpräparationen als Gelbkomponenten beschrieben. Bei diesen Pigmentpräparationen handelt es sich um Mischungen bestimmter Metallkomplexe, bevorzugt 1:1-Nickelkomplex der Azobarbitursäure, mit geringen Mengen einer Eisenverbindung sowie wenigstens einer weiteren Metallverbindung,

Diese bekannten Pigmente bzw. die damit hergestellten Pigmentpräparationen sind noch nicht in allen Anforderungen an Brillanz und Farbreinheit der damit hergestellten Farbfilter zufriedenstellend.

Es wurden neue gelbe Metallazopigmente gefunden, die sich hervorragend zum Abtönen grüner Farbtöne von Gelbpigmenten, beispielsweise des CI Pigment Green 36, in Pigmentpräparationen bei der Herstellung von Farbfiltern eignen.

Überraschenderweise gelingt es durch den Einsatz der neuen Metallazopigmente als Gelbkomponente in Pigmentpräparationen für Farbfilter, die beschriebenen coloristischen Eigenschaften des grünen Farbtons nochmals deutlich zu verbessern.

Die Erfindung betrifft daher Metallazopigmente enthaltend das Addukt aus
a) mindestens zwei Metallazoverbindungen der Formel (I) oder deren tautomeren Formen 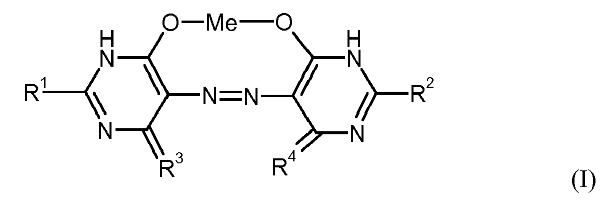 worin
   R¹ und R² unabhängig voneinander für OH, NH₂ oder NHR⁵ stehen,
   R³ und R⁴ unabhängig voneinander für =O oder =NR⁵ stehen,
   R⁵ für Wasserstoff oder Alkyl steht, und
   Me für ein 2- oder 3-wertiges Metallion ausgewählt aus der Reihe Ni²⁺, Zn²⁺, Cu²⁺, Al³⁺_{2/3}, Fe²⁺, Fe³⁺_{2/3}, Co²⁺ und Co³⁺_{2/3} steht,
   mit der Maßgabe, dass die Menge an Metallionen aus der Reihe Zn²⁺ und Ni²⁺ 95 bis 100 Mol-% beträgt und die Menge an Metallionen ausgewählt aus der Reihe Cu²⁺, Al³⁺_{2/3}, Fe²⁺, Fe³⁺_{2/3}, Co²⁺ und Co³⁺_{2/3} 0 bis 5 Mol-% beträgt, jeweils bezogen auf ein Mol aller Verbindungen der Formel (I), und
   wobei das Molverhältnis von Zn- zu Ni- Metallionen in der Summe der Verbindungen der Formel (I) 9 : 1 bis 1 : 9 beträgt,
   und
b) mindestens einer Verbindung der Formel (II) 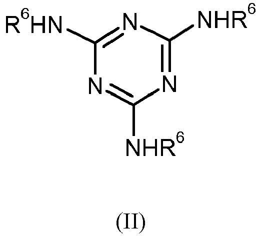 worin
   R⁶ für Wasserstoff oder Alkyl steht,
   dadurch gekennzeichnet, dass das Metallazopigment im Röntgendiffraktogramm bei einer Gitterkonstanten von d = 10,3 ( ± 0,2) Å ein Signal S₁ mit einer Intensität I₁ aufweist und im Gitterkonstantenbereich von d = 16,05 Å bis d = 11,78 Å kein Signal S₂ aufweist dessen Intensität I₂ im Verhältnis zur Intensität I₁ von Signal S₁, ausgedrückt als Quotient I₂/I₁ der untergrundkorrigierten Intensitäten, den Wert 0,02 überschreitet.

Bevorzugt sind Metallazopigmente enthaltend das Addukt aus
a) mindestens zwei Metallazoverbindungen der Formel (I) oder deren tautomeren Formen 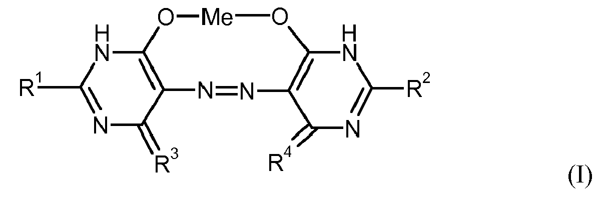 worin
   R¹ und R² unabhängig voneinander für OH, NH₂ oder NHR⁵ stehen,
   R³ und R⁴ unabhängig voneinander für =O oder =NR⁵ stehen,
   R⁵ für Wasserstoff oder C₁-C₄-Alkyl steht, und
   Me für ein 2- oder 3-wertiges Metallion ausgewählt aus der Reihe Ni²⁺, Zn²⁺, Cu²⁺, Al³⁺_{2/3}, Fe²⁺, Fe³⁺_{2/3}, Co²⁺ und Co³⁺_{2/3} steht,
   mit der Maßgabe, dass die Menge an Metallionen aus der Reihe Zn²⁺ und Ni²⁺ 95 bis I₁/I₂ I₁/I₂100 Mol-% beträgt und die Menge an Metallionen ausgewählt aus der Reihe Cu²⁺, Al³⁺_{2/3}, Fe²⁺, Fe³⁺_{2/3}, Co²⁺ und Co³⁺_{2/3} 0 bis 5 Mol-% beträgt, jeweils bezogen auf ein Mol aller Verbindungen der Formel (I), und
   wobei das Molverhältnis von Zn- zu Ni- Metallionen in der Summe der Verbindungen der Formel (I) 9 : 1 bis 1 : 9 beträgt,
   und
b) mindestens einer Verbindung der Formel (II) 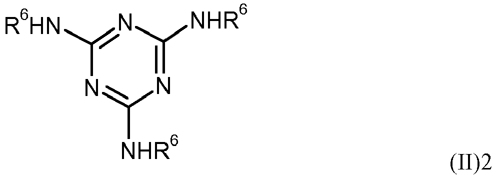 worin
   R⁶ für Wasserstoff oder C₁-C₄-Alkyl steht, das gegebenenfalls mit einer oder mehreren OH-Gruppen substituiert ist,
   dadurch gekennzeichnet, dass das Metallazopigment im Röntgendiffraktogramm bei einer Gitterkonstanten von d = 10,3 ( ± 0,2) Å ein Signal S₁ mit einer Intensität I₁ aufweist und im Gitterkonstantenbereich von d = 16,05 Å bis d = 11,78 Å kein Signal S₂ aufweist dessen Intensität I₂ im Verhältnis zur Intensität I₁ von Signal S₁, ausgedrückt als Quotient I₂/I₁ der untergrundkorrigierten Intensitäten, den Wert 0,02 überschreitet.

Ganz besonders bevorzugt sind Metallazopigmente enthaltend das Addukt aus
a) einer Metallazoverbindung der Formel (Ia) oder einer ihrer tautomeren Formen 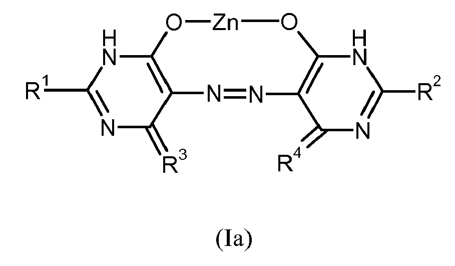 worin
   R¹ und R² unabhängig voneinander für OH, NH₂ oder NHR⁵ stehen,
   R³ und R⁴ unabhängig voneinander für =O oder =NR⁵ stehen,
   R⁵ für Wasserstoff oder C₁-C₄-Alkyl steht, und
   einer Metallazoverbindung der Formel (Ib) oder einer ihrer tautomeren Formen 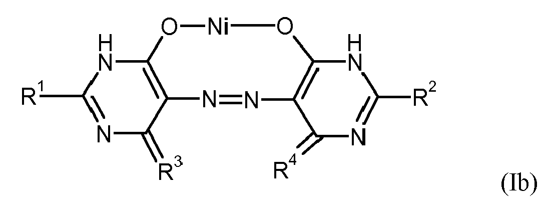 worin
   R¹ und R² unabhängig voneinander für OH, NH₂ oder NHR⁵ stehen,
   R³ und R⁴ unabhängig voneinander für =O oder =NR⁵ stehen, und
   R⁵ für Wasserstoff oder C₁-C₄-Alkyl steht, und
   und gegebenenfalls einer Verbindung der Formel (Ic) 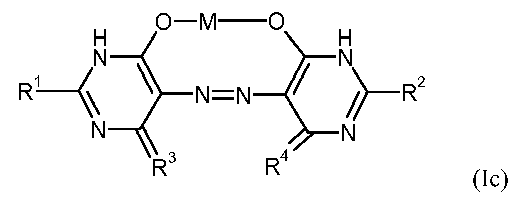 worin
   R¹ und R² unabhängig voneinander für OH, NH₂ oder NHR⁵ stehen,
   R³ und R⁴ unabhängig voneinander für =O oder =NR⁵ stehen, und
   R⁵ für Wasserstoff oder C₁-C₄-Alkyl steht, und
   M für ein 2- oder 3-wertiges Metallion ausgewählt aus der Reihe Cu²⁺, Al³⁺_{2/3}, Fe²⁺, Fe³⁺_{2/3}, Co²⁺ und Co³⁺_{2/3} steht,
   mit der Maßgabe, dass die Menge an Metallionen aus der Reihe Zn²⁺ und Ni²⁺ 95 bis 100 Mol-% beträgt, und die Menge an Metallionen ausgewählt aus der Reihe Cu²⁺, Al³⁺_{2/3}, Fe²⁺, Fe³⁺_{2/3}, Co²⁺ und Co³⁺_{2/3} 0 bis 5 Mol-% beträgt, jeweils bezogen auf ein Mol aller Verbindungen der Formel (I),
   wobei das Molverhältnis von Zn- zu Ni- Metallionen in der Summe der Verbindungen der Formeln (Ia) und (Ib) 9 : 1 bis 1 : 9 beträgt,
   und
b) mindestens einer Verbindung der Formel (II) 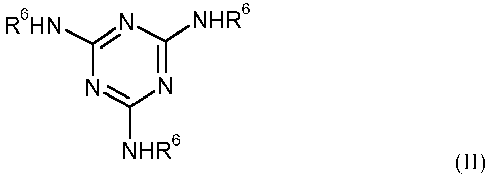 worin
   R⁶ für Wasserstoff oder C₁-C₄-Alkyl steht, das gegebenenfalls mit einer oder mehreren OH-Gruppen substituiert ist,
   dadurch gekennzeichnet, dass das Metallazopigment im Röntgendiffraktogramm bei einer Gitterkonstanten von d = 10,3 ( ± 0,2) Å ein Signal S₁ mit einer Intensität I₁ aufweist und im Gitterkonstantenbereich von d = 16,05 Å bis d = 11,78 Å kein Signal S₂ aufweist dessen Intensität I₂ im Verhältnis zur Intensität I₁ von Signal S₁, ausgedrückt als Quotient I₂/I₁ der untergrundkorrigierten Intensitäten, den Wert 0,02 überschreitet.

Insbesondere bevorzugt sind Metallazopigmente enthaltend das Addukt aus
a) einer Metallazoverbindung der Formel (Ia) oder einer ihrer tautomeren Formen 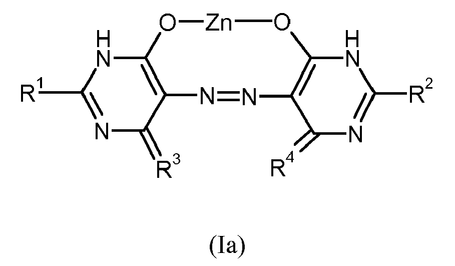 worin
   R¹ und R² unabhängig voneinander für OH, NH₂ oder NHR⁵ stehen,
   R³ und R⁴ unabhängig voneinander für =O oder =NR⁵ stehen,
   R⁵ für Wasserstoff oder C₁-C₄-Alkyl steht, und
   einer Metallazoverbindung der Formel (Ib) oder einer ihrer tautomeren Formen 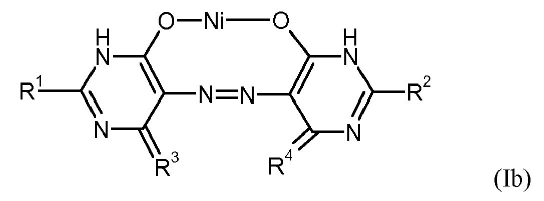 worin
   R¹ und R² unabhängig voneinander für OH, NH₂ oder NHR⁵ stehen,
   R³ und R⁴ unabhängig voneinander für =O oder =NR⁵ stehen, und
   R⁵ für Wasserstoff oder C₁-C₄-Alkyl steht,
   mit der Maßgabe, dass die Menge an Metallionen aus der Reihe Zn²⁺ und Ni²⁺ 100 Mol-% beträgt, bezogen auf ein Mol aller Verbindungen (Ia) und (Ib),
   wobei das Molverhältnis von Zn- zu Ni- Metallionen in der Summe der Verbindungen der Formeln (Ia) und (Ib) 9 : 1 bis 1 : 9 beträgt,
   und
b) mindestens einer Verbindung der Formel (II) 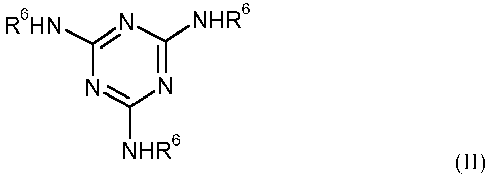 worin
   R⁶ für Wasserstoff oder C₁-C₄-Alkyl steht, das gegebenenfalls mit einer oder mehreren OH-Gruppen substituiert ist,
   dadurch gekennzeichnet, dass das Metallazopigment im Röntgendiffraktogramm bei einer Gitterkonstanten von d = 10,3 ( ± 0,2) Å ein Signal S₁ mit einer Intensität I₁ aufweist und im Gitterkonstantenbereich von d = 16,05 Å bis d = 11,78 Å kein Signal S₂ aufweist dessen Intensität I₂ im Verhältnis zur Intensität I₁ von Signal S₁, ausgedrückt als Quotient I₂/I₁ der untergrundkorrigierten Intensitäten, den Wert 0,02 überschreitet.

Weiterhin sind insbesondere bevorzugt Metallazopigmente enthaltend das Addukt aus
a) einer Metallazoverbindung der Formel (Ia) oder einer ihrer tautomeren Formen 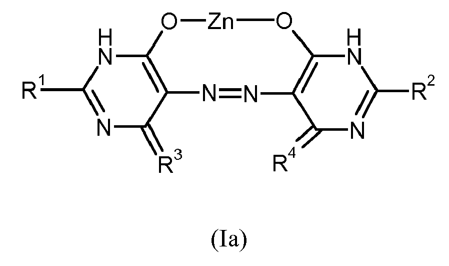 worin
   R¹ und R² für OH stehen,
   R³ und R⁴ für =O stehen,
   und
   einer Metallazoverbindung der Formel (Ib) oder einer ihrer tautomeren Formen 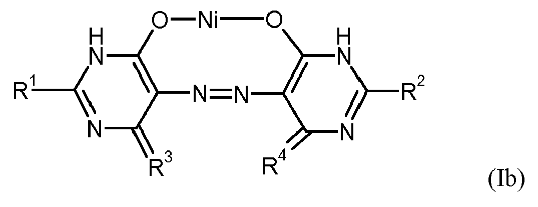 worin
   R¹ und R² für OH stehen,
   R³ und R⁴ für =O stehen,
   mit der Maßgabe, dass die Menge an Metallionen aus der Reihe Zn und Ni 100 Mol-% beträgt, bezogen auf ein Mol an Verbindungen (Ia) und (Ib),
   wobei das Molverhältnis von Zn- zu Ni- Metallionen in der Summe der Verbindungen der Formeln (Ia) und (Ib) 9 : 1 bis 1 : 9 beträgt,
   und
b) mindestens einer Verbindung der Formel (II) 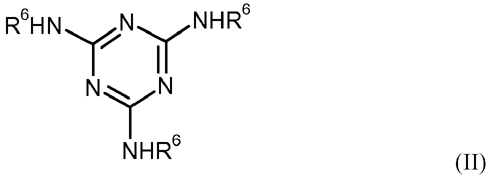 worin
   R⁶ für Wasserstoff steht,
   dadurch gekennzeichnet, dass das Metallazopigment im Röntgendiffraktogramm bei einer Gitterkonstanten von d = 10,3 ( ± 0,2) Å ein Signal S₁ mit einer Intensität I₁ aufweist und im Gitterkonstantenbereich von d = 16,05 Å bis d = 11,78 Å kein Signal S₂ aufweist dessen Intensität I₂ im Verhältnis zur Intensität I₁ von Signal S₁, ausgedrückt als Quotient I₂/I₁ der untergrundkorrigierten Intensitäten, den Wert 0,02 überschreitet.

Im Gegensatz zu einer physikalischen Mischung aus der reinen Ni-Azoverbindung und der reinen Zn-Azoverbindungen die den oben angegebenen Strukturen der Formeln (Ia) und (Ib) entsprechen, handelt es sich bei den in den erfindungsgemäßen Metallazopigmenten enthaltenen Metallazoverbindungen der Formel (I) um chemische Mischverbindungen bei denen die Ni- und Zn-Atome, sowie gegebenenfalls weitere Metallionen M,in ein gemeinsames Kristallgitter eingebaut sind. Experimentell kann dieser Unterschied gezeigt werden durch die unterschiedlichen Röntgendiffraktogramme der physikalischen Mischungen und der chemischen Mischverbindungen. So unterscheiden sich beispielsweise die Röntgendiffraktogramme der chemischen Mischverbindungen der erfindungsgemäßen Metallazopigmente enthaltend jeweils das Addukt aus der Ni/Zn-Azoverbindung und Melamin gemäß den Beispielen 3 bis 5 in charakteristischer Weise von den Röntgendiffraktogrammen der physikalischen Mischungen der einzelnen Pigment wie aus dem Vergleich der Messwerte der Tabellen 3 bis 5 mit den Messwerten der Tabellen 6 bis 8 deutlich wird.

Substituenten in der Bedeutung von Alkyl bezeichnen beispielsweise geradkettiges oder verzweigtes C₁-C₆-Alkyl, das gegebenenfalls ein- oder mehrfach, gleich oder verschieden substituiert sein kann, beispielsweise durch Halogen, wie Chlor, Brom oder Fluor; -OH, -CN, -NH₂ oder C₁-C₆-Alkoxy . Bei den erfindungsgemäßen Metallazopigmenten handelt es sich um Addukte von a) Metallazoverbindungen der Formel (I) mit b) Verbindungen der Formel (II). Als Addukte sind dabei generell zusammengesetzte Moleküle zu verstehen. Dabei kann die Bindung zwischen den Molekülen beispielsweise durch intermolekulare Wechselwirkungen oder Lewis-Säure-Base Wechselwirkungen oder durch koordinative Bindungen erfolgen. Der Begriff Addukt soll im Sinne der vorliegenden Erfindung daher generell alle Arten von Ein- und Anlagerungsverbindungen umfassen.

Unter den Begriffen "Einlagerungsverbindung" oder "Anlagerungsverbindung" im Sinne der vorliegenden Erfindung sollen beispielsweise Verbindungen verstanden werden, die aufgrund von intermolekularen Wechselwirkungen wie Van-der Waals-Wechselwirkungen oder auch Lewis-Säure-Base Wechselwirkungen gebildet werden. Dabei hängt es sowohl von den chemischen Eigenschaften der einzulagernden Komponente, aber auch von der chemischen Natur des Wirtsgitters ab, wie die Einlagerung abläuft. Solche Verbindungen werden häufig auch als Interkalationsverbindungen bezeichnet. Im chemischen Sinn versteht man darunter die Einlagerung von Molekülen, Ionen (selten auch Atomen) in chemische Verbindungen.

Weiterhin sollen darunter auch Einschlussverbindungen, sogenannte Clathrate, verstanden werden. Diese stellen Verbindungen zweier Stoffe dar, von denen ein Gastmolekül in ein Gitter oder Käfig aus einem Wirtsmolekül eingelagert ist.

Unter den Begriffen "Einlagerungsverbindung" oder "Anlagerungsverbindung" im Sinne der vorliegenden Erfindung sollen auch Einlagerungsmischkristalle (auch interstitielle Verbindung) verstanden werden. Es handelt es sich hierbei um eine chemische, nichtstöchiometrische, kristalline Verbindung aus mindestens zwei Elementen.

Weiterhin sollen unter den Begriffen "Einlagerungsverbindung" oder "Anlagerungsverbindung" im Sinne der vorliegenden Erfindung auch Verbindungen verstanden werden, die aufgrund von koordinativen Bindungen oder Komplexbindungen gebildet werden. Als solche Verbindungen werden z.B. Substitutionsmischkristall oder Austauschmischkristall bezeichnet, bei dem mindestens zwei Stoffe einen gemeinsamen Kristall bilden und die Atome der zweiten Komponente auf regulären Gitterplätzen der ersten Komponente sitzen.

Verbindung, die mit der Verbindung der Formel (I) eine Ein- oder Anlagerungsverbindung bilden können sowohl organische als auch anorganische Verbindungen sein. Im folgenden werden diese Verbindungen als Ein- / Anlagerungsverbindungen bezeichnet.

Prinzipiell geeignete Ein-/Anlagerungsverbindungen entstammen den verschiedenartigsten Verbindungsklassen. Aus rein praktischen Gründen sind solche Verbindungen bevorzugt, die unter Normalbedingungen (25°C, 1 bar) flüssig oder fest sind.

Von den flüssigen Substanzen sind generell solche bevorzugt, die einen Siedepunkt von 100°C oder darüber, bevorzugt von größer gleich 150°C bei 1 bar, aufweisen. Geeignete Ein-/ Anlagerungsverbindungen sind generell acyclische und cyclische organische Verbindungen, z.B. aliphatische und aromatische Kohlenwasserstoffe, die substituiert sein können, z.B. durch OH, COOH, NH₂, substituiertes NH₂, CONH₂, substituiertes CONH₂, SO₂NH₂, substituiertes SO₂NH₂, SO₃H, Halogen, NO₂, CN, -SO₂-Alkyl, -SO₂-Aryl, -O-Alkyl, -O-Aryl, -O-Acyl.

Carbonsäure- und Sulfonsäureamide sind eine bevorzugte Gruppe von Ein- / Anlagerungsverbindungen, insbesondere geeignet sind auch Harnstoff und substituierte Harnstoffe wie Phenylharnstoff, Dodecylharnstoff und andere sowie deren Polykondensate mit Aldehyden, insbesondere Formaldehyd; Heterocyclen wie Barbitursäure, Benzimidazolon, Benzimidazolon-5-sulfonsäure, 2,3-Dihydroxychinoxalin, 2,3-Dihydroxychinoxalin-6-sulfonsäure, Carbazol, Carbazol-3,6-disulfonsäure, 2-Hydroxychinolin, 2,4-Dihydroxychinolin, Caprolactam, Melamin, 6-Phenyl-1,3,5-triazin-2,4-diamin, 6-Methyl-1,3,5-triazin-2,4-diamin, Cyanursäure.

Erfindungsgemäß werden als Ein-/Anlagerungsverbindung solche der Formel (II) eingesetzt. Insbesondere bevorzugt ist dabei Melamin.

Ebenfalls als Ein-/ Anlagerungsverbindungen prinzipiell geeignet sind Polymere, vorzugsweise wasserlösliche Polymere, z.B. Ethylen-propylenoxid-Blockpolymere, vorzugsweise mit einem Mₙ größer gleich 1.000, insbesondere von 1.000 bis 10.000 g/mol, Polyvinylalkohol, Poly-(meth)-acrylsäuren, modifizierte Cellulose, wie Carboxymethylcellulosen, Hydroxyethyl- und -propylcellulosen, Methyl- und Ethylhydroxyethylcellulosen. Die Menge an Verbindung der Formel (II) die mit den Metallazoverbindungen der Formel (I) ein Addukt bilden liegt in der Regel bei 5 % bis 300 Mol-%, bevorzugt bei 10 bis 250 Mol-% und insbesondere bei 100 bis 200 Mol-%, jeweils bezogen auf ein Mol an Verbindung der Formel (I). Das erfindungsgemäße Metallazopigment besitzt vorzugsweise eine spezifische Oberfläche (m²/g) von 50 bis 200 m²/g, insbesondere 80 bis 160 m²/g, ganz besonders bevorzugt 100 bis 150 m²/g. Die Oberfläche wird nach DIN 66131 ermittelt: Bestimmung der spezifischen Oberfläche von Feststoffen durch Gasadsorption nach Brunauer, Emmett und Teller (B.E.T). Besonders bevorzugt besteht das erfindungsgemäße Metallazopigment aus dem Addukt aus a) mindestens zwei Metallazoverbindungen der Formel (I) und b) mindestens einer Verbindung der Formel (II) jeweils in ihren allgemeinen und bevorzugen Bedeutungen.

Die erfindungsgemäßen Metallazopigmente sind erhältlich durch Umsetzung von i Verbindungen der Formel (I), oder deren Tautomeren,Form ihrer Alkalisalze, bevorzugt ihrer Natrium- oder Kaliumsalze, in Gegenwart von mindestens einer Verbindungen der Formel (II) mit Nickel- und Zinksalzen und gegebenenfalls einem oder mehreren Metallsalzen aus der Reihe der Kupfer-, Aluminium-, Eisen- und Kobaltsalze.

Weiterer Gegenstand der vorliegenden Erfindung ist ein Verfahren zur Herstellung der erfindungsgemäßen Metallazopigmenten das dadurch gekennzeichnet ist, dass man eine Verbindung der Formel (Id), oder deren Tautomere, 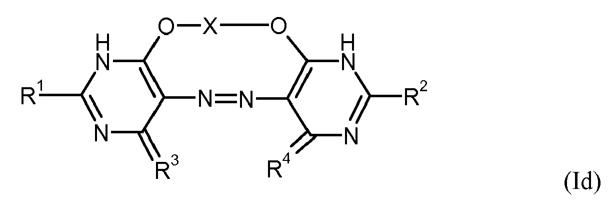 worin
X für ein Alkalimetallion, vorzugsweise für ein Natrium- oder Kaliumion steht,
R¹ und R² unabhängig voneinander für OH, NH₂ oder NHR⁵ stehen,
R³ und R⁴ unabhängig voneinander für =O oder =NR⁵ stehen,
R⁵ für Wasserstoff oder Alkyl steht, und

in Gegenwart von mindestens einer Verbindung der Formel (II) mit mindestens einem Nickelsalz und mindestens einem Zinksalz und gegebenenfalls mit mindestens einem weiteren Metallsalz aus der Reihe der Kupfer-, Aluminium-, Eisen- und Kobaltsalze umsetzt.

Zur Durchführung des erfindungsgemäßen Verfahrens werden im Allgemeinen pro Mol an Verbindung der Formel (Id) 0,05 bis 0,9 Mol mindestens eines Nickelsalzes, 0,05 bis 0,9 Mol mindestens eines Zinksalzes und 0,05 bis 0 Mol mindestens eines Metallsalzes aus der Reihe der Kupfer- Aluminium-, Eisen- und Kobaltsalze eingesetzt.

Bevorzugt werden pro Mol an Verbindung der Formel (Id) 0,2 bis 0,8 Mol mindestens eines Nickelsalzes, 0,1 bis 0,75 Mol mindestens eines Zinksalzes und 0,05 bis 0 Mol mindestens eines Metallsalzes aus der Reihe der Kupfer- Aluminium-, Eisen- und Kobaltsalze eingesetzt.

Ganz besonders bevorzugt werden pro Mol an Verbindung der Formel (Id) 0,4 bis 0,6 Mol mindestens eines Nickelsalzes, 0,2 bis 0,6 Mol mindestens eines Zinksalzes und 0 bis 0,05 Mol mindestens eines Metallsalzes aus der Reihe der Kupfer- Aluminium-, Eisen- und Kobaltsalze eingesetzt.

Im Allgemeinen werden zur Durchführung des erfindungsgemäßen Verfahrens pro Mol an Verbindung der Formel (Id) 0,05 bis 4 Mol, bevorzugt 0,5 bis 2,5 Mol und ganz besonders bevorzugt 1,0 bis 2,0 Mol an Verbindung der Formel (II) eingesetzt.

Insbesondere bevorzugt ist die Herstellung von binären Zink-/Nickelazobarbitursäure-Melamin Addukten. Hierzu werden pro Mol an Verbindung der Formel (Id) 0,05 - 0,95 Mol, bevorzugt 0,2 -? 0,8 Mol und ganz besonders bevorzugt 0,4 - 0,7 Mol an mindestens einem Nickelsalz und 0,05 -? 0,95 Mol, bevorzugt 0,15 - 0,6 Mol und besonders bevorzugt 0,25 - 0,45 Mol an mindestens einem Zinksalz und 0,05 - 4 Mol, bevorzugt 0,5 - 2,5 und besonders bevorzugt 1 - 2 Mol an mindestens einer Verbindung der Formel (II) eingesetzt.

Das erfindungsgemäße Verfahren wird im Allgemeinen bei einer Temperatur von 60 bis 95 °C in wässriger Lösung bei einem PH-Wert unterhalb von 7 durchgeführt. Die erfindungsgemäß einzusetzenden Nickel- und Zinksalze und die gegebenenfalls einzusetzenden weiteren Metallsalze aus der Reihe der Kupfer-, Aluminium-, Eisen- und Kobaltsalze können einzeln oder als Gemisch untereinander, bevorzugt in Form einer wässrigen Lösung eingesetz werden. Die Verbindungen der Formel (II) können ebenfalls einzeln oder als Mischung untereinander zugegeben werden, bevorzugt in Form der Feststoffe..

Im Allgemeinen wird das erfindungsgemäße Verfahren so durchgeführt, dass die Azoverbindung der Formel (Id), vorzugsweise als Na- oder K-Salz, vorgelegt wird, dass eine oder mehrere der ein- bzw. anzulagernden Verbindung oder Verbindungen der Formel (II), vorzugsweise Melamin, zugegeben wird und danach mit mindestens einem Nickelsalz und mindestens einem Zinksalz und gegebenenfalls einem oder mehreren Metallsalzen aus der Reihe der Kupfer-, Aluminium-, Eisen- und Kobaltsalze, vorzugsweise in Form der wässrigen Lösungen dieser Salze, umgesetzt wird, vorzugsweise bei pH-Werten kleiner 7. Zur Einstellung des pH-Wertes eignen sich Natronlauge, Kalilauge, Natriumcarbonat, Natriumhydrogencarbonat, Kaliumcarbonat und Kaliumhydrogencarbonat.

Als Nickel- und Zinksalze kommen vorzugsweise deren wasserlösliche Salze in Frage, insbesondere Chloride, Bromide, Acetate, Formiate, Nitrate, Sulfate usw. Bevorzugt eingesetzte Nickel- und Zinksalze besitzen eine Wasserlöslichkeit von mehr als 20 g/l, insbesondere mehr als 50 g/l bei 20°C.

Als weitere Metallsalze aus der Reihe der Kupfer-, Aluminium-, Eisen- und Kobaltsalze kommen vorzugsweise deren wasserlösliche Salze in Frage, insbesondere deren Chloride, Bromide, Acetate, Nitrate und Sulfate, bevorzugt deren Chloride.

Die auf diese Weise erhaltenen erfindungsgemäßen Metallazopigmente können dann durch Filtration ihrer wässrigen Suspension als wässriger Nutschkuchen isoliert werden. Dieser Nutschkuchen kann beispielsweise nach Waschen mit heißem Wasser, nach üblichen Trocknungsverfahren getrocknet werden.

Als Trocknungsverfahren kommen beispielsweise die Schaufeltrocknung oder die Sprühtrocknung entsprechender wässriger Slurries in Frage.

Anschließend kann das Pigment nachgemahlen werden.

Sofern die erfindungsgemäßen Metallazopigmente für die gewünschte Anwendung zu kornhart bzw. zu dispergierhart sind, können sie beispielsweise gemäß der in DE-A 19 847 586 beschriebenen Methode in kornweiche Pigmente umgewandelt werden.

Ein weiterer Gegenstand der vorliegenden Erfindung sind Pigmentpräparationen enthaltend wenigstens ein erfindungsgemäßes Metallazopigment. Die erfindungsgemäßen Pigmentpräparationen sind vorzugsweise bei Raumtemperatur fest. Sie können neben dem erfindungsgemäßen Metallazopigment weitere Zusätze enthalten.

Weitere Zusätze sind beispielsweise Dispergiermittel, Carbonsäure- und Sulfonsäureamide sowie für Pigmentpräparation übliche Zusätze.

Unter Dispergiermittel im Rahmen dieser Anmeldung wird eine, die Pigmentteilchen in ihrer feinen partikulären Form in wässrigen Medien stabilisierende Substanz verstanden. Unter fein partikulär wird vorzugsweise eine Feinverteilung von 0,001 bis 5 µm verstanden, insbesondere von 0,005 bis 1 µm, besonders bevorzugt von 0,005 bis 0,5 µm. Die erfindungsgemäße Präparation liegt vorzugsweise fein partikulär vor.

Geeignete Dispergiermittel sind beispielsweise anionisch, kationisch, amphoter oder nichtionogen.

Das Dispergiermittel wird vorzugsweise in einer Menge von 0,1 bis 100 Gew.-%, insbesondere 0,5 bis 60 Gew.-%, bezogen auf das eingesetzte erfindungsgemäße Metallazopigment, in der Pigmentpräparation, verwendet.

Selbstverständlich kann die erfindungsgemäße Präparation noch weitere Zusätze enthalten. So können beispielsweise die als die Viskosität einer wässrigen Suspension erniedrigenden und den Feststoffgehalt erhöhenden Zusätze wie Carbonsäure- und Sulfonsäureamide in einer Menge von bis zu 10 Gew.-%, bezogen auf die Präparation zugesetzt werden.

Weiterhin bevorzugt sind daher die erfindungsgemäßen Pigmentpräparationen enthaltend neben dem erfindungsgemäßen Metallazopigment wenigstens ein Dispergiermittel.

Bevorzugt handelt es sich bei den Pigmentpräparationen um feste Präparationen, die vorzugsweise als Pulver oder Granulate vorliegen.

Die erfindungsgemäßen Metallazopigmente zeichnen sich durch besonders gute Dispergierbarkeit und eine hohe Farbstärke aus. Chroma und Transparenz sind hervorragend einstellbar.

Die erfindungsgemäßen Pigmentpräparationen eignen sich hervorragend für alle Pigmentanwendungszwecke.

Zum Beispiel eignen sie sich zum Pigmentieren von Lacken aller Art für die Herstellung von Druckfarben, Leimfarben oder Binderfarben, für die Massefärbung von Papier, für die Massefärbung von synthetischen, halbsynthetischen oder natürlichen makromolekularen Stoffen, wie z.B. Polyvinylchlorid, Polystyrol, Polyamid, Polyethylen oder Polypropylen. Sie können auch für die Spinnfärbung von natürlichen, regenerierten oder künstlichen Fasern, wie z.B. Cellulose-, Polyester-, Polycarbonat-, Polyacrylnitril- oder Polyamidfasern, sowie zum Bedrucken von Textilien und Papier verwendet werden. Aus diesen Pigmenten können feinteilige, stabile, wässrige Pigmentierungen von Dispersions- und Anstrichfarben, die für die Papierfärbung, für den Pigmentdruck von Textilien, für den Laminatdruck oder für die Spinnfärbung von Viskose brauchbar sind, durch Mahlen oder Kneten in Gegenwart von nichtionogenen, anionischen oder kationischen Tensiden hergestellt werden.

Die Pigmente eignen sich hervorragend für Ink Jet Anwendungen und für Farbfilter für Flüssigkristallanzeigen.

Besonders bevorzugt sind solche erfindungsgemäßen Pigmentpräparationen, enthaltend
wenigstens ein erfindungsgemäßes Metallazopigment und
c) eine organische Verbindung ausgewählt aus der Gruppe der Terpene, Terpenoide, Fettsäuren, Fettsäureester und der Homo- oder Copolymere, wie statistische- oder Block-Copolymere mit einer Löslichkeit in pH neutralem Wasser bei 20°C von weniger als 1 g/l, insbesondere weniger als 0,1 g/l.

Besonders bevorzugt sind diese erfindungsgemäßen Pigmentpräparationen in fester Form, vorzugsweise in Form von Pulver oder Granulat.

Die organische Verbindung der Komponente (c) ist vorzugsweise bei Raumtemperatur (20°C) unter Normalatmosphäre fest oder flüssig und weist im Falle, dass sie flüssig ist, einen Siedepunkt von vorzugsweise >100°C, insbesondere >150°C auf.

Bevorzugte Polymere besitzen sowohl einen hydrophilen wie auch einen hydrophoben vorzugsweise polymeren Molekülteil. Beispiele derartiger Polymere sind statistische Copolymere auf Basis von Fettsäuren oder langkettigen C₁₂-C₂₂-Kohlenwasserstoffen und Polyalkylenglykolen, insbesondere Polyethylenglykol. Ferner Block-Copolymere auf Basis von (Poly)Hydroxy Fettsäuren und Polyalkylenglykol, insbesondere Polyethylenglykol, sowie Pfropf-Copolymere auf Basis von Poly(meth)acrylat und Polyalkylenglykol, insbesondere Polyethylenglykol.

Als bevorzugte Verbindungen aus der Gruppe der Terpene, Terpenoide, Fettsäuren und Fettsäureester seien genannt: Ocimen, Myrcen, Geraniol, Nerol, Linalool, Citronellol, Geranial, Citronellal, Neral, Limonen, Menthol, beispielsweise (-)-Menthol, Menthon oder bicyclische Monoterpene, gesättigte und ungesättigte Fettsäuren mit 6 bis 22 C-Atomen, wie beispielsweise Ölsäure, Linolsäure und Linolensäure oder Mischungen davon.

Als organische Verbindungen der Komponente (c) kommen ferner auch die oben als Ein-/Anlagerungsverbindungen genannten infrage, soweit sie den für die Verbindung der Komponente € gewünschten Kriterien gehorchen.

Sofern die ein- oder anzulagernde Verbindung und die Verbindung der Komponente c) identisch sind, differenziert man über die Auswaschbarkeit der Verbindung c) mit einem geeigneten Lösungsmittel. Besonders bevorzugte Pigmentpräparationen enthalten:

| | |
|---|---|
| 50 - 99 Gew.-% | an wenigstens einem erfindungsgemäßen Metallazopigment und |
| 1 - 50 Gew.-% | vorzugsweise 2 bis 50 Gew.-% an wenigstens einer Verbindung der Komponente €. |

Gegebenenfalls enthält die erfindungsgemäße Pigmentpräparation zusätzlich ein oberflächenaktives Mittel €.

Geeignete oberflächenaktive Mittel € sind beispielsweise anionischer, kationischer, amphoterer oder nichtionogener Natur.

Geeignete anionische oberflächenaktive Mittel sind insbesondere Kondensationsprodukte von aromatischen Sulfonsäuren mit Formaldehyd, wie Kondensationsprodukte aus Formaldehyd und Alkylnaphthalinsulfonsäuren oder aus Formaldehyd, Naphthalinsulfonsäuren und/oder Benzolsulfonsäuren, Kondensationsprodukte aus gegebenenfalls substituiertem Phenol mit Formaldehyd und Natriumbisulfit. Geeignet sind außerdem oberflächenaktive Mittel aus der Gruppe der Sulfobernsteinsäureester sowie Alkylbenzolsulfonate. Außerdem ionisch modifizierte, insbesondere sulfatierte oder carboxilierte, alkoxylierte Fettsäurealkohole oder deren Salze. Als alkoxylierte Fettsäurealkohole werden insbesondere solche mit 5 bis 120, vorzugsweise 5 bis 60, insbesondere mit 5 bis 30 Ethylenoxid versehene C₆-C₂₂-Fettsäurealkohole, die gesättigt oder ungesättigt sind, verstanden. Weiterhin kommen vor allem Ligninsulfonate in Betracht, z.B. solche, die nach dem Sulfit- oder Kraft-Verfahren gewonnen werden. Vorzugsweise handelt es sich um Produkte, die zum Teil hydrolysiert, oxidiert, propoxyliert, sulfoniert, sulfomethyliert oder desulfoniert und nach bekannten Verfahren fraktioniert werden, z.B. nach dem Molekulargewicht oder nach dem Sulfonierungsgrad. Auch Mischungen aus Sulfit- und Kraftligninsulfonaten sind gut wirksam. Besonders geeignet sind Ligninsulfonate mit einem durchschnittlichen Molekulargewicht zwischen 1 000 und 100 000 g/mol, einem Gehalt an aktivem Ligninsulfonat von mindestens 80 Gew.-% und vorzugsweise mit niedrigem Gehalt an mehrwertigen Kationen. Der Sulfonierungsgrad kann in weiten Grenzen variieren.

Als nichtionische oberflächenaktive Mittel kommen beispielsweise in Frage: Umsetzungsprodukte von Alkylenoxiden mit alkylierbaren Verbindungen, wie z.B. Fettalkoholen, Fettaminen, Fettsäuren, Phenolen, Alkylphenolen, Arylalkylphenolen, wie Styrol-Phenol-Kondensate, Carbonsäureamiden und Harzsäuren. Hierbei handelt es sich z.B. um Ethylenoxidaddukte aus der Klasse der Umsetzungsprodukte von Ethylenoxid mit:
a1) gesättigten und/oder ungesättigten Fettalkoholen mit 6 bis 22 C-Atomen oder
b1) Alkylphenolen mit 4 bis 12 C-Atomen im Alkylrest oder
c1) gesättigten und/oder ungesättigten Fettaminen mit 14 bis 20 C-Atomen oder
d1) gesättigten und/oder ungesättigten Fettsäuren mit 14 bis 20 C-Atomen oder
e1) hydrierte und/oder unhydrierte Harzsäuren.

Als Ethylenoxid-Addukte kommen insbesondere die unter a1) bis e1) genannten alkylierbaren Verbindungen mit 5 bis 120, insbesondere 5 bis 100, insbesondere 5 bis 60, besonders bevorzugt 5 bis 30 Mol Ethylenoxid in Frage.

Als oberflächenaktive Mittel eignen sich ebenfalls die aus DE-A 19 712 486 oder aus DE-A 19 535 246 bekannten Ester des Alkoxylierungsproduktes der Formel (X), die der Formel (XI) entsprechen sowie diese gegebenenfalls in Mischung mit den zugrundeliegenden Verbindungen der Formel (X). Das Alkoxylierungsprodukt eines Styrol-Phenol-Kondensats der Formel (X) ist wie nachfolgend definiert: 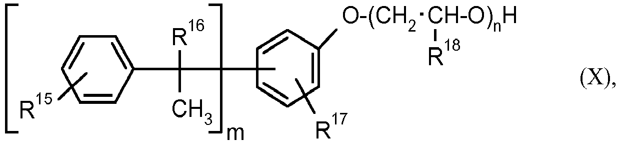 in der
R¹⁵ Wasserstoff oder C₁-C₄-Alkyl bedeutet,
R¹⁶ für Wasserstoff oder CH₃ steht,
R¹⁷ Wasserstoff, C₁-C₄-Alkyl, C₁-C₄-Alkoxy, C₁-C₄-Alkoxycarbonyl oder Phenyl bedeutet,
m eine Zahl von 1 bis 4 bedeutet,
n eine Zahl von 6 bis 120 bedeutet,
R¹⁸ für jede durch n indizierte Einheit gleich oder verschieden ist und für Wasserstoff, CH₃ oder Phenyl steht, wobei im Falle der Mitanwesenheit von CH₃ in den verschiedenen -(-CH₂-CH(R¹⁸)-O-)-Gruppen in 0 bis 60 % des Gesamtwertes von n R¹⁸ für CH₃ und in 100 bis 40 % des Gesamtwertes von n R¹⁸ für Wasserstoff steht und wobei im Falle der Mitanwesenheit von Phenyl in den verschiedenen -(-CH₂-CH(R¹⁸)-O-)-Gruppen in 0 bis 40 % des Gesamtwertes von n R¹⁸ für Phenyl und in 100 bis 60 % des Gesamtwertes von n R¹⁸ für Wasserstoff steht.

Die Ester der Alkoxylierungsprodukte (X) entsprechen der Formel (XI) 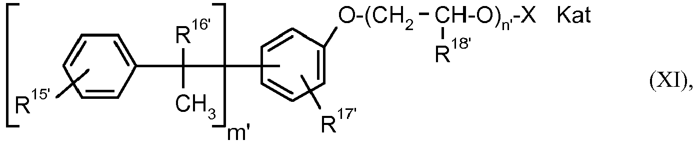 in der
R^{15'}, R^{16'}, R^{17'}, R^{18'}, m' und n' den Bedeutungsumfang von R¹⁵, R¹⁶, R¹⁷, R¹⁸, m bzw. n, jedoch unabhängig hiervon, annehmen,
X die Gruppe -SO₃, -SO₂, -PO₃ oder -CO-(R¹⁹)-COO bedeutet,
Kat ein Kation aus der Gruppe von H, Li, Na, K, NH₄ oder HO-CH₂CH₂-NH₃ ist, wobei im
Falle von X = -PO₃ zwei Kat vorliegen und

R¹⁹ für einen zweiwertigen aliphatischen oder aromatischen Rest steht, vorzugsweise für C₁-C₄-Alkylen, insbesondere Ethylen, C₂-C₄- einfach ungesättigte Reste, insbesondere Acetylen oder gegebenenfalls substituiertes Phenylen, insbesondere ortho-Phenylen steht, wobei als mögliche Substituenten vorzugsweise C₁-C₄-Alkyl, C₁-C₄-Alkoxy, C₁-C₄-Alkoxycarbonyl oder Phenyl in Frage kommen.

Als ein bevorzugtes oberflächenaktive Mittel wird die Verbindung der Formel (XI) eingesetzt. Vorzugsweise eine Verbindung der Formel (XI), worin X einen Rest der Formel -CO-(R¹⁹)-COO-bedeutet und R¹⁹ die obige Bedeutung besitzt.

Bevorzugt ist es ebenfalls als oberflächenaktive Mittel eine Verbindung der Formel (XI) zusammen mit einer Verbindung der Formel (X) einzusetzen. Vorzugsweise enthält das oberflächenaktive Mittel in diesem Fall 5 bis 99 Gew.-% der Verbindung (XI) und 1 bis 95 Gew.-% der Verbindung (X).

Das oberflächenaktive Mittel der Komponente e) wird vorzugsweise in einer Menge von 0,1 bis 100 Gew.-%, insbesondere 0,5 bis 60 Gew.-%, bezogen auf das eingesetzte Pigment verwendet.

Selbstverständlich kann die erfindungsgemäße Pigmentpräparation noch weitere Zusätze enthalten. So können beispielsweise viskositätserniedrigende oder feststofferhöhende Zusätze im Verlauf der Herstellung wässriger Suspensionen in einer Menge von bis zu 10 Gew.-%, bezogen auf die Präparation, eingebracht werden.

Weitere Zusätze sind beispielsweise anorganische und organische Basen sowie für Pigmentpräparation übliche Zusätze.

Als Basen sind zu nennen: Alkalihydroxide, wie beispielsweise NaOH, KOH oder organische Amine wie Alkylamine, insbesondere Alkanolamine oder Alkylalkanolamine.

Als besonders bevorzugt sind zu nennen Methylamin, Dimethylamin, Trimethylamin, Ethanolamin, n-Propanolamin, n-Butanolamin, Diethanolamin, Triethanolamin, Methylethanolamin oder Dimethylethanolamin.

Als Carbonsäure- und Sulfonsäureamide sind beispielsweise geeignet: Harnstoff und substituierte Harnstoffe wie Phenylharnstoff, Dodecylharnstoff und andere; Heterocyclen wie Barbitursäure, Benzimidazolon, Benzimidazolon-5-sulfonsäure, 2,3-Dihydroxychinoxalin, 2,3-Dihydroxychin oxalin-6-sulfonsäure, Carbazol, Carbazol-3,6-disulfonsäure, 2-Hydroxychinolin, 2,4-Dihydroxychinolin, Caprolactam, Melamin, 6-Phenyl-1,3,5-triazin-2,4-diamin, 6-Methyl-1,3,5-triazin-2,4-diamin, Cyanursäure.

Die Base ist gegebenenfalls bis zu einer Menge von 20 Gew.-%, vorzugsweise bis 10 Gew.-%, bezogen auf das Pigment enthalten.

Weiterhin können die erfindungsgemäßen Pigmentpräparationen herstellungsbedingt noch anorganische und/oder organische Salze enthalten.

Besonders bevorzugt bestehen die erfindungsgemäßen Präparationen zu mehr als 90 Gew.-%, vorzugsweise mehr als 95 Gew.-% und insbesondere mehr als 97 Gew.-% aus mindestens einem erfindungsgemäßen Metallazopigment, mindestens einer organischen Verbindung der Komponente c) und gegebenenfalls mindestens einem oberflächenaktiven Mittel der Komponente e) und gegebenenfalls mindestens einer Base.

Ein weiterer Gegenstand der vorliegenden Erfindung ist ein Verfahren zur Herstellung der erfindungsgemäßen Pigmentpräparationen das dadurch gekennzeichnet ist, dass man mindestens ein erfindungsgemäßes Metallazopigment, mindestens eine organischen Verbindung der Komponente c) und gegebenenfalls mindestens ein oberflächenaktives Mittel der Komponente e) und gegebenenfalls mindestens eine Base miteinander vermischt.

Ebenfalls Gegenstand der vorliegenden Erfindung ist die Verwendung der erfindungsgemäßen Metallazopigmente oder der erfindungsgemäßen Pigmentpräparationen zur Herstellung von Farbfiltern für Flüssigkristallanzeigen. Im Folgenden sei diese Verwendung am Beispiel der Pigment-Dispersionsmethode nach dem Photolackverfahren beschrieben.

Die erfindungsgemäße Verwendung der erfindungsgemäßen Pigmentpräparationen zur Herstellung von Farbfiltern ist beispielsweise dadurch gekennzeichnet, dass mindestens ein erfindungsgemäßes Metallazopigment oder eine erfindungsgemäße Pigmentpräparation, insbesondere feste Pigmentpräparation, gegebenenfalls mit einem Bindemittelharz und einem organischen Lösungsmittel, gegebenenfalls unter Zusatz eines Dispergiermittels, homogenisiert und anschließend kontinuierlich oder diskontinuierlich auf eine Teilchengröße nach Anzahl (elektronenmikroskopische Bestimmung) von 99,5 % <1000 nm, vorzugsweise 95 % <500 nm und insbesondere 90 % <200 nm nasszerkleinert wird.

Als Nasszerkleinerungsverfahren kommen beispielsweise Rührer- oder Dissolverdispergierung, Mahlen mittels Rührwerkskugel- oder -perlmühlen, Kneter, Walzenstuhl, Hochdruckhomogenisierung oder Ultraschalldispergierung in Frage.

Während der Dispergierbehandlung oder im Anschluss daran erfolgt die Zugabe von mindestens einem photohärtbaren Monomeren und einem Photoinitiator. Im Anschluss an die Dispergierung kann noch weiteres Bindemittelharz, Lösungsmittel oder für Photolacke übliche Zuschlagstoffe eingebracht werden, wie es für die gewünschte photosensitive Beschichtungsmitteleinstellung (Photolack) zur Herstellung der Farbfilter erforderlich ist. Im Rahmen dieser Erfindung wird unter Photolack eine Präparation verstanden, die wenigstens ein photohärtbares Monomer und einen Photoinitiator enthält.

Gegenstand der vorliegenden Erfindung ist auch ein Verfahren zur Herstellung von Farbfiltern Flüssigkristallanzeigen das dadurch gekennzeichnet ist, dass man mindestens ein erfindungsgemäßes Metallazopigment oder eine erfindungsgemäße Pigmentpräparation, gegebenenfalls mit einem Bindemittelharz und einem organischen Lösungsmittel, gegebenenfalls unter Zusatz eines Dispergiermittels, homogenisiert und anschließend kontinuierlich oder diskontinuierlich auf eine Teilchengröße nach Anzahl (elektronenmikroskopische Bestimmung) von 99,5 % <1000 nm, nasszerkleinert und während der Dispergierbehandlung oder im Anschluss daran mindestens ein photohärtbares Monomer und einem Photoinitiator zugibt.

Als mögliche Dispergiermittel kommen allgemein handelsübliche wie beispielsweise polymere, ionogene oder nicht-ionogene Dispergiermittel bspw. auf Basis von Polycarbonsäuren oder Polysulfonsäuren, sowie Polyethylenoxid-Polypropylenoxid-Block-Copolymere in Betracht. Ferner können auch Derivate organischer Farbstoffe als Dispergiermittel oder Co-Dispergiermittel verwendet werden.

Bei der Herstellung der Farbfilter fallen daher "Zubereitungen" an, die bezogen auf die Zubereitung enthalten:
- wenigstens ein erfindungsgemäßes Metallazopigment,
- gegebenenfalls ein Bindemittelharz,
- wenigstens ein organisches Lösungsmittel sowie
- gegebenenfalls ein Dispergiermittel.

In einer bevorzugten Ausführungsform enthält die Zubereitung (Angaben bezogen auf Zubereitung):

| | |
|---|---|
| 1 - 50 Gew.-% | eines erfindungsgemäßen Metallazopigments |
| 0 - 20 Gew.-% | Bindemittelharz |
| 0 - 20 Gew.-% | Dispergiermittel |
| 10 - 94 Gew.-% | organisches Lösungsmittel |

Die Beschichtung des Photolackes auf eine Platte zur Erzeugung der gefärbten Bildelementmuster kann entweder durch direkten oder indirekten Auftrag geschehen. Als Auftragsmethoden seien bspw. genannt: Roller-Coating, Spin-Coating, Spray-Coating, Dip-Coating und Air-Knife-Coating.

Als Platten kommen je nach Verwendung beispielsweise in Frage: transparente Gläser wie weiße oder blaue Glasplatte, mit Silikat beschichtete blaue Glasplatte, Kunstharzplatte oder -filme auf Basis von z.B. Polyester-, Polycarbonat-, Acryl-, oder Vinylchloridharz, ferner Metallplatten auf Basis von Aluminium, Kupfer, Nickel, oder Stahl sowie Keramikplatten oder Halbleiterplatten mit aufgebrachten photoelektrischen Transferelementen.

Die Auftragung erfolgt im Allgemeinen so, dass die Schichtdicke der erhaltenen photosensitiven Schicht bei 0,1 bis 10 µm liegt.

Im Anschluss an den Auftrag kann eine thermische Trocknung der Schicht erfolgen.

Die Belichtung erfolgt vorzugsweise, indem die photosensitive Schicht einem aktiven Lichtstrahl vorzugsweise in Form eines Bildmusters mittels Photomaske ausgesetzt wird. Hierdurch wird an den belichteten Stellen die Schicht gehärtet. Geeignete Lichtquellen sind z.B.: Hochdruck- und Ultrahochdruckquecksilberdampflampe, Xenon-, Metallhalogenid-, Fluoreszenzlampe sowie Laserstrahl im sichtbaren Bereich.

Durch die Entwicklung im Anschluss an die Belichtung wird der unbelichtete Teil der Beschichtung entfernt und man erhält die gewünschte Bildmusterform der Farbelemente. Übliche Entwicklungsmethoden umfassen das Besprühen mit oder Tauchen in wässrige alkalische Entwicklerlösung oder in ein organisches Lösungsmittel, das anorganische Alkali wie z.B. Natrium- oder Kaliumhydroxid, Natriummetasilikat oder organische Basen wie Monoethanolamin, Diethanolamin, Triethanolamin, Triethylamin oder deren Salze enthält.

Nach der Entwicklung erfolgt in der Regel eine thermische Nachtrocknung/-härtung der Bildmuster. Weitere Pigmente:
Die erfindungsgemäße Verwendung der Metallazopigmente ist vorzugsweise dadurch gekennzeichnet, dass diese alleine oder in Mischung mit anderen, für die Herstellung von Farbfiltern üblichen, Pigmenten in den Farbfiltern bzw. Pigmentpräparationen oder Zubereitungen für Farbfilter eingesetzt werden.

Diese "anderen Pigmente" können sowohl andere Metallsalze einer Azo-Verbindung der Formel (I) oder darauf basierende Pigmentpräparationen sein als auch andere anorganische oder organische Pigmente.

Hinsichtlich der Auswahl anderer gegebenenfalls mitzuverwendender Pigmente besteht erfindungsgemäß keine Einschränkung. Es kommen sowohl anorganische als auch organische Pigmente in Frage.

Bevorzugte organische Pigmente sind z.B. solche der Monoazo-, Disazo-, verlackte Azo-, ß-Naphthol-, Napthol AS-, Benzimidazolon-, Disazokondensations-, Azometallkomplex-, Isoindolin- und Isoindolinon-Reihe, ferner polycyclische Pigmente wie z.B. aus der Phthalocyanin-, Chinacridon-, Perylen-, Perinon-, Thioindigo-, Anthrachinon-, Dioxazin-, Chinophthalon- und Diketopyrrolopyrrol-Reihe. Außerdem verlackte Farbstoffe wie Ca-, Mg- und Al-Lacke von sulfonsäure- oder carbonsäuregruppenhaltigen Farbstoffen.

Beispiele für gegebenenfalls mitzuverwendende andere organische Pigmente sind:
Colour Index Pigment Yellow 12, 13, 14, 17, 20, 24, 74, 83, 86, 93, 94, 109, 110, 117, 125, 137, 138, 139, 147, 148, 150, 153, 154, 166, 173, 185, oder
Colour Index Pigment Orange 13, 31, 36, 38, 40, 42, 43, 51, 55, 59, 61, 64, 65, 71, 72, 73 oder
Colour Index Pigment Red 9, 97, 122, 123, 144, 149, 166, 168, 177, 180, 192, 215, 216, 224, 254, 272, oder
Colour Index Pigment Green 7, 10, 36, 37, 45, 58 oder
Colour Index Pigment Blue 15, 15:1, 15:2, 15:3, 15:4, 15:6, 16 sowie
Colour Index Pigment Violett 19, 23.

Darüber hinaus können auch lösliche organische Farbstoffe in Verbindung mit den erfindungsgemäßen neuen Pigmenten eingesetzt werden.

Sofern "andere Pigmente" zusätzlich eingesetzt werden, beträgt der Anteil an erfindungsgemäßem Metallazopigment vorzugsweise 1-99 Gew.-%, insbesondere 20-80 Gew.-% bezogen auf die eingesetzte Gesamtmenge aller Pigmente. Besonders bevorzugt sind die erfindungsgemäßen Pigmentpräparationen sowie Zubereitungen, enthaltend mindestens ein erfindungsgemäßes Metallazopigment und C.I. Pigment Green 36 und/oder C.I. Pigment Green 58 im Verhältnis von 20 bis 80 Gew.-% Metallazopigment zu 80 bis 20 Gew.-% C.I. Pigment Green 36 und/oder C.I. Pigment Green 58, vorzugsweise von 40 bis 60 Gew.- % zu 60 bis 40 Gew.-%.

Als Bindemittelharze, die zusammen mit dem "Pigment" oder darauf basierender Pigmentpräparationen in Farbfiltern bzw. in den Zubereitungen zur Herstellung von Farbfiltern z.B. nach der Pigment-Dispersionsmethode, eingesetzt werden können, besteht erfindungsgemäß keine besondere Einschränkung, insbesondere kommen für die Anwendung in Farbfiltern an sich bekannte filmbildende Harze in Frage.

Beispielsweise kommen Bindemittelharze aus der Gruppe der Celluloseharze wie Carboxymethylhydroxyethylcellulose und Hydroxyethylcellulose, Acrylharze, Alkydharze, Melaminharze, Epoxidharze, Polyvinylalkohole, Polyvinylpyrrolidone, Polyamide, Polyamidimine, Polyimide,

Polyimidvorstufen wie solche der Formel (14), offenbart in JP-A 11 217 514 und deren Veresterungsprodukte in Frage.

Als solche sind beispielsweise Umsetzungsprodukte von Tetracarbonsäuredianhydrid mit Diaminen zu nennen.

Als Bindemittelharze kommen auch solche in Frage, die photopolymerisierbare, ungesättigte Bindungen enthalten. Die Bindemittelharze können beispielsweise solche aus der Gruppe der Acrylharze aufgebaut sein. Dabei sind insbesondere Mono- und Copolymere polymerisierbarer Monomere zu nennen wie z.B. (Meth)acrylsäuremethylester, (Meth)acrylsäureethylester, (Meth)acrylsäurepropylester, (Meth)acrylsäurebutylester, Styrol und Styrolderivate, ferner Copolymere zwischen carboxylgruppentragenden polymerisierbaren Monomeren wie (Meth)acrylsäure, Itaconsäure, Maleinsäure, Maleinsäureanhydrid, Maleinsäuremonoalkylester, insbesondere mit Alkyl von 1 bis 12 C-Atomen, und polymerisierbare Monomere wie (Meth)acrylsäure, Styrol und Styrolderi-vate, wie z.B. α-Methylstyrol, m- oder p-Methoxystyrol, p-Hydroxystyrol. Als Beispiele seien genannt Umsetzungsprodukte von carboxylgruppenhaltigen polymeren Verbindungen mit Verbindungen, die jeweils einen Oxiranring und eine ethylenisch ungesättigte Verbindung enthalten wie z.B. Glycidyl(meth)acrylat, Acrylglycidylether und Itaconsäuremonoalkylglycidylether usw., ferner Umsetzungsprodukte von carboxylgruppenhaltigen polymeren Verbindungen mit Verbindungen, die jeweils eine Hydroxylgruppe und eine ethylenisch ungesättigte Verbindung (ungesättigte Alkohole) enthalten wie Allylalkohol, 2-Buten-4-ol, Oleylalkohol, 2-Hydroxyethyl(meth)acrylat, N-Methylolacrylamid usw.; weiterhin können derartige Bindemittelharze auch ungesättigte Verbindungen, die freie Isocyanatgruppen besitzen, enthalten.

Im Allgemeinen liegt die Äquivalenz der Ungesättigtheit (Molgewicht Bindemittelharz pro ungesättigte Verbindung) der genannten Bindemittelharze bei 200 bis 3 000, insbesondere 230 bis 1 000, um sowohl eine ausreichende Photopolymerisierbarkeit und Härte des Films zu erreichen. Der Säurewert liegt im Allgemeinen bei 20 bis 300, insbesondere 40 bis 200, um eine genügende Alkali-Entwicklungsfähigkeit nach der Belichtung des Films zu erzielen.

Das mittlere Molgewicht der einzusetzenden Bindemittelharze liegt zwischen 1 500 und 200 000, insbesondere 10 000 bis 50 000 g/mol.

Die bei der erfindungsgemäßen Verwendung der Pigmentpräparationen für Farbfilter eingesetzten organischen Lösungsmittel sind z.B. Ketone, Alkylenglykolether, Alkohole und aromatische Verbindungen. Beispiele aus der Gruppe der Ketone sind: Aceton, Methylethylketon, Cyclohexanon etc.; aus der Gruppe der Alkylenglykolether: Methylcellosolve (Ethylenglykolmonomethylester), Butylcellosolve (Etylenglykolmonobutylether) Methylcellosolveacetat, Ethylcellosolveacetat, Butylcellosolveacetat, Ethylenglykolmonopropylether, Ethylenglykolmonohexylether, Ethylenglykoldimethylether, Diethylenglykolethylether, Diethylenglykoldiethylether, Propylenglykolmonomethylether, Propylenglykolmonoethylether, Propylenglykolmonopropylether, Propylenglykolmonobutylether, Propylenglykolmonomethyletheracetat, Diethylenglykolmethyletheracetat, Diethylenglykolethyletheracetat, Diethylenglykolpropyletheracetat, Diethylenglykolisopropyletheracetat, Diethylenglykolbutyletheracetat, Diethylenglykol-t-butyletheracetat, Triethylenglykolmethyletheracetat, Triethylenglykolethyletheracetat, Triethylenglykolpropyletheracetat, Triethylenglykolisopropyletheracetat, Triethylenglykolbutyletheracetat, Triethylenglykol-t-butyletheracetat, etc.; aus der Gruppe der Alkohole: Methylalkohol, Ethylalkohol, Isopropylalkohol, n-Butylalkohol, 3-Methyl-3-methoxybutanol, etc.; aus der Gruppe der aromatischen Lösungsmittel Benzol, Toluol, Xylol, N-Methyl-2-Pyrrolidon, N-Hydroxymethyl-2-Essigsäureethylester, etc.

Weitere andere Lösungsmittel sind 1,2-Propandioldiacetat, 3-Methyl-3-methoxybutylacetat, Essigsäureethylester, Tetrahydrofuran, etc. Die Lösungsmittel können einzeln oder in Gemischen untereinander eingesetzt werden.

Die Erfindung betrifft weiterhin einen Photolack, enthaltend wenigstens ein erfindungsgemäßes Metallazopigment oder wenigstens eine erfindungsgemäße Pigmentpräparation und wenigstens ein photohärtbares Monomer sowie wenigstens einen Photoinitiator.

Die photohärtbaren Monomere enthalten im Molekül wenigstens eine reaktive Doppelbindung und gegebenenfalls andere reaktive Gruppen.

Als photohärtbare Monomere seien in diesem Zusammenhang insbesondere reaktive Lösungsmittel bzw. sog. Reaktiwerdünner verstanden z.B. aus der Gruppe der mono-, di- , tri- und multifunktionelle Acrylate und Methacrylate, Vinylether, sowie Glycidylether. Als zusätzlich enthaltene reaktive Gruppen kommen in Frage Allyl-, Hydroxy-, Phosphat-, Urethan-, sek. Amin- und N-Alkoxymethylgruppen.

Derartige Monomere sind dem Fachmann bekannt und beispielsweise in *[*Römpp Lexikon, Lacke und Druckfarben, Dr. Ulrich Zorll, Thieme Verlag Stuttgart-New York, 1998, S. 491/492*]* aufgeführt.

Die Auswahl der Monomere richtet sich insbesondere nach der Art und Intensität der verwendeten Strahlenart der Belichtung, der gewünschten Reaktion mit dem Photoinitiator und den Filmeigenschaften. Es können auch Kombinationen von Monomeren eingesetzt werden.

Als Photoreaktionsstarter oder Photoinitiatoren seinen Verbindungen verstanden, die infolge der Adsorption sichtbarer oder ultravioletter Strahlung reaktive Zwischenprodukte bilden, die eine Polymerisationsreaktion beispielsweise der oben genannten Monomeren und/oder Bindemittelharze auslösen können. Photoreaktionsstarter sind ebenfalls allgemein bekannt und können ebenfalls aus *[*Römpp Lexikon, Lacke und Druckfarben, Dr. Ulrich Zorll, Thieme Verlag Stuttgart-New York, 1998, S. 445/446*]* entnommen werden.

Erfindungsgemäß besteht keine Einschränkung hinsichtlich der einzusetzenden photohärtbaren Monomeren oder Photoinitiatoren.

Die Erfindung betrifft bevorzugt Photolacke enthaltend
A) wenigstens ein erfindungsgemäßes Metallazopigment, insbesondere in Mischung mit anderen Pigmenten, vorzugsweise C.I. Pigment Green 36 und/oder Pigment Green 58 oder eine darauf basierende erfindungsgemäße Pigmentpräparation,
B1) wenigstens ein photohärtbares Monomer,
B2) wenigstens einen Photoinitiator,
C1) gegebenenfalls ein organisches Lösungsmittel,
D) gegebenenfalls ein Dispergiermittel,
E) gegebenenfalls ein Bindemittelharz,
   sowie gegebenenfalls weitere Zusätze.

Erfindungsgemäß besteht auch keine Einschränkung hinsichtlich der Technologie zur Erzeugung der gefärbten Bildelementmuster auf Basis der erfindungsgemäß zu verwendenden Pigmente oder feste Pigmentpräparationen. Neben dem oben beschriebenen photolithographischen Verfahren sind andere Verfahren wie Offset-Druck, chemisches Ätzen oder Ink Jet Druck ebenso geeignet. Die Auswahl der geeigneten Bindemittelharze und Lösungsmittel bzw. Pigment-Trägermedien sowie weitere Zusätze sind auf das jeweilige Verfahren abzustimmen. Beim Ink Jet Verfahren, worunter sowohl der thermische als auch mechanische und piezzo-mechanische Ink Jet Druck verstanden werden, kommen neben rein organischen auch wässrig-organische Trägermedien für die Pigmente und gegebenenfalls Bindemittelharze in Frage, wässrig-organische Trägermedien werden sogar bevorzugt.

Die folgenden Beispiele sollen die vorliegende Erfindung erläutern ohne sie jedoch darauf zu beschränken.

### Beispiele

### Herstellung der Vorstufe Azobarbitursäure (Vorschrift 1)

In 1100 g destillierten Wasser von 85°C wurden 46,2 g Diazobarbitursäure und 38,4 g Barbitursäure eingetragen. Anschließend wurde mit wässriger Kalilauge auf ca. pH 5 gestellt und 90 Min. nachgerührt.

### Beispiel 1: Herstellung von Pigment A (nicht erfindungsgemäß):

Eine nach Vorschrift 1 hergestellte Azobarbitursäure (0,3 mol) wurde bei 82°C mit 1500 g destilliertem Wasser versetzt. Danach wurden 75,7 g Melamin (0,6 mol) eingetragen. Anschließend wurden 0,3 Mol einer ca. 30%igen Zinkchloridlösung zugetropft. Nach 3h bei 82°C wurde mit KOH auf ca. pH 5,5 gestellt. Danach wurde bei 90°C mit ca. 300 g destilliertem Wasser verdünnt. Anschließend wurden 34 g 30 %ige Salzsäure zugetropft und 12h bei 90°C getempert. Danach wurde mit wässriger Kalilauge auf ca. pH 5 gestellt. Anschließend wurde das Pigment auf einer Saugnutsche isoliert, gewaschen und bei 80°C im Vakuumtrockenschrank getrocknet und in einer üblichen Labormühle ca. 2 Minuten gemahlen. (Pigment A = Addukt aus Zinkazobarbitursäure und Melamin)

### Beispiel 2: Herstellung von Pigment B (nicht erfindungsgemäß):

Eine nach Vorschrift 1 hergestellte Azobarbitursäure (0,3 mol) wurde bei 82°C mit 1500 g destilliertem Wasser versetzt. Anschließend wurden 10 g 30 % ige Salzsäure zugetropft wodurch der PH-Wert auf... 2 - 2,5...eingestellt wurde. Danach wurden 79,4 g Melamin (0,63 mol) eingetragen. Anschließend wurden 0,3 Mol einer ca. 25%igen Nickelchloridlösung zugetropft. Nach 3h bei 82°C wurde mit KOH auf ca. pH 5,5 gestellt. Danach wurde bei 90°C mit ca. 100 g destilliertem Wasser verdünnt. Anschließend wurden 21 g 30 % ige Salzsäure zugetropft und 12h bei 90°C getempert. Danach wurde mit wässriger Kalilauge auf ca. pH 5 gestellt. Anschließend wurde das Pigment auf einer Saugnutsche isoliert, gewaschen und bei 80°C im Vakuumtrockenschrank getrocknet und in einer üblichen Labormühle ca. 2 Minuten gemahlen. (Pigment B = Addukt aus Nickelazobarbitursäure und Melamin).

### Beispiele 3-5: Herstellung der Pigmente C, D und E (erfindungsgemäß)

In den nachfolgenden erfindungsgemäßen Beispielen 3 bis 5 wurde wie in Beispiel 2 verfahren jedoch wurde die Nickelchloridlösung durch eine Mischlösung aus Nickelchlorid und Zinkchlorid ersetzt.

### Beispiel 3: 0,3 Mol Ni ersetzt durch 0,225 Mol Ni + 0,075 Mol Zn (Pigment C = Melamin-Addukt der Zink/Nickel-azobarbitursäure Mischverbindung mit, 25 Mol% Zn und 75 Mol% Nickel)

### Beispiel 4: 0,3 Mol Ni ersetzt durch 0,150 Mol Ni + 0,150 Mol Zn (Pigment D = Melamin-Addukt der Zink/Nickel-azobarbitursäure Mischverbindung mit, 50 Mol% Zn und 50 Mol% Nickel)

**Beispiel 5:** 0,3 Mol Ni ersetzt durch 0,075 Mol Ni + 0,225 Mol Zn (Pigment E = Melamin-Addukt der Zink/Nickel-azobarbitursäure Mischverbindung mit, 75 Mol% Zn und 25 Mol% Nickel)

### Röntgendiffraktometrische Untersuchung

Die röntgendiffraktometrischen Messungen wurden in einem Theta/Theta-Reflexionsdiffraktometer vom Typ PANalytical EMPYREAN mit PIXcel-Zähler durchgeführt, das zur Identifizierung kristalliner Phasen geeignet ist.

### Geräteeinstellungen:

| | |
|---|---|
| Diffraktometer System | EMPYREAN |
| Messprogramm | Scan 5-40 Standard_Reflexion VB, 17 mm bestrahlte Länge, 15mm Maske |
| Startposition [°2Th.] | 5,0066 |
| Endposition [°2Th.] | 39,9896 |
| Schrittweite [°2Th.] | 0,0130 |
| Schrittzeit [s] | 48,1950 |
| Scan Modus | Continuous |
| OED Betriebsart | Scanning |
| OED Länge [°2Th.] | 3,35 |
| Art der Divergenzblende | Automatisch |
| Bestrahlte Länge [mm] | 17,00 |
| Probenlänge [mm] | 10,00 |
| Anodenmaterial | Cu |
| K-Alphal [Å] | 1,54060 |
| K-Alpha2 [Å] | 1,54443 |
| K-Beta [Å] | 1,39225 |
| K-A2 / K-A1 Verhältnis | 0,50000 |
| Filter | Nickel |
| Generatoreinstellung | 40 mA, 40 kV |
| Goniometer Radius [mm] | 240,00 |
| Abstand Focus-Div.blende [mm] | 100,00 |
| Primärstrahl-Monochromator | Kein |
| Probendrehung | Ja |

### Durchführung:

Aus den nach den Synthesebeispielen 1 bis 5 hergestellten Pigmenten wurden Proben 1 bis 8 mit folgender Zusammensetzung bereitgestellt:
Probe 1: 10 g Pigment B (100 Mol-% Nickel) nicht erfindungsgemäß
Probe 2: 10 g Pigment A (100 Mol-% Zink) nicht erfindungsgemäß
Probe 3: 10 g Pigment C (25 Mol-% Zink / 75 Mol-% Nickel) erfindungsgemäß
Probe 4: 10 g Pigment D (50 Mol-% Zink / 50 Mol-% Nickel) erfindungsgemäß
Probe 5: 10 g Pigment E (75 Mol-% Zink / 25 Mol-% Nickel) erfindungsgemäß
Probe 6: 2,5 g Pigment A und 7,5 g Pigment B (physikalische Mischung 25 Mol-% Zink und 75 Mol-% Nickel) nicht erfindungsgemäß
Probe 7: 5,0 g Pigment A und 5,0 g Pigment B (physikalische Mischung 50 Mol-% Zink und 50 Mol-% Nickel) nicht erfindungsgemäß
Probe 8: 7,5 g Pigment A und 2,5 g Pigment B (physikalische Mischung 75 Mol-% Zink und 25 Mol-% Nickel) nicht erfindungsgemäß

Für die Theta/Theta- Messungen wurde jeweils eine Menge der zu prüfenden Probe in die Vertiefung des Probenhalters eingebracht. Die Oberfläche der Probe wurde mittels eins Schabers geglättet.

Dann wurde der Probenhalter in den Probenwechsler des Diffraktometers eingebracht und die Messung durchgeführt. Die Theta-Werte der gemessenen Proben wurden gemäß der oben beschriebenen Methode bestimmt. Auf diese Weise wurden Messungen der Proben 1 bis 8 vorgenommen. Die dabei nach der Untergrundkorrektur ermittelten Reflexionswerte wurden in den Tabellen 1 bis 8 wiedergegeben.

**Tabelle 1: Probe 1: 10 g Pigment B (100 Mol-% Nickel) nicht erfindungsgemäß**

| **Nr.** | **Pos. [°2Th.]** | **d [Å]** | **Int. [cts]** | **Rel. Int. [%]** |
|---|---|---|---|---|
| 1 | 8,4937 | 10,41046 | 10737,84 | 92,96 |
| 2 | 9,2193 | 9,59272 | 5937,69 | 51,40 |
| 3 | 9,9533 | 8,87958 | 713,64 | 6,18 |
| 4 | 15,3758 | 5,75807 | 2133,92 | 18,47 |
| 5 | 15,6201 | 5,67326 | 3580,93 | 31,00 |
| 6 | 16,4733 | 5,38130 | 3356,57 | 29,06 |
| 7 | 17,1275 | 5,17721 | 5106,25 | 44,21 |
| 8 | 17,8337 | 4,96963 | 1264,69 | 10,95 |
| 9 | 18,6258 | 4,76398 | 9912,31 | 85,81 |
| 10 | 19,1260 | 4,63666 | 2584,15 | 22,37 |
| 11 | 20,2938 | 4,37604 | 9150,29 | 79,21 |
| 12 | 23,2611 | 3,82409 | 6588,29 | 57,04 |
| 13 | 23,8331 | 3,73359 | 7138,31 | 61,80 |
| 14 | 24,9686 | 3,56631 | 3015,45 | 26,10 |
| 15 | 26,3622 | 3,38086 | 11551,25 | 100,00 |
| 16 | 27,2200 | 3,27624 | 10120,18 | 87,61 |
| 17 | 27,9441 | 3,19033 | 1697,71 | 14,70 |
| 18 | 30,1838 | 2,96095 | 3156,17 | 27,32 |
| 19 | 30,4187 | 2,93862 | 3540,55 | 30,65 |
| 20 | 31,4155 | 2,84526 | 1883,03 | 16,30 |
| 21 | 31,9223 | 2,80123 | 2459,97 | 21,30 |
| 22 | 32,2692 | 2,77420 | 2448,70 | 21,20 |
| 23 | 34,5979 | 2,59263 | 1200,82 | 10,40 |
| 24 | 35,8594 | 2,50426 | 1032,86 | 8,94 |
| 25 | 36,5485 | 2,45861 | 3095,45 | 26,80 |
| 26 | 37,6990 | 2,38618 | 5516,95 | 47,76 |
| 27 | 38,2824 | 2,34921 | 1075,19 | 9,31 |
| 28 | 39,8281 | 2,26153 | 769,37 | 6,66 |

**Tabelle 2: Probe 2: 10 g Pigment A (100 Mol-% Zink) nicht erfindungsgemäß**

| **Nr.** | **Pos. [°2Th.]** | **d [Å]** | **Int. [cts]** | **Rel. Int. [%]** |
|---|---|---|---|---|
| 1 | 6,2962 | 14,03826 | 2925,18 | 23,19 |
| 2 | 10,1053 | 8,74633 | 1252,80 | 9,93 |
| 3 | 10,5689 | 8,37065 | 2083,81 | 16,52 |
| 4 | 14,3072 | 6,19078 | 919,16 | 7,29 |
| 5 | 16,4263 | 5,39659 | 1052,71 | 8,35 |
| 6 | 17,0074 | 5,20917 | 474,33 | 3,76 |
| 7 | 20,0526 | 4,42446 | 460,54 | 3,65 |
| 8 | 20,8493 | 4,26069 | 1906,56 | 15,12 |
| 9 | 21,1699 | 4,19688 | 1393,01 | 11,04 |
| 10 | 26,0149 | 3,42237 | 3794,79 | 30,09 |
| 11 | 26,6611 | 3,34363 | 11939,89 | 94,67 |
| 12 | 26,8850 | 3,31356 | 10515,37 | 83,37 |
| 13 | 27,3308 | 3,26321 | 12612,46 | 100,00 |
| 14 | 29,0144 | 3,07757 | 2098,82 | 16,64 |
| 15 | 31,4157 | 2,84760 | 868,19 | 6,88 |
| 16 | 32,0284 | 2,79219 | 722,81 | 5,73 |
| 17 | 35,9510 | 2,49809 | 501,44 | 3,98 |

**Tabelle 3: Probe 3: 10 g Pigment C (25 Mol-% Zink / 75 Mol-% Nickel) erfindungsgemäß**

| **Nr.** | **Pos. [°2Th.]** | **d [Å]** | **Int. [cts]** | **Rel. Int. [%]** |
|---|---|---|---|---|
| 1 | 8,5100 | 10,39063 | 10820,62 | 98,21 |
| 2 | 9,3063 | 9,50322 | 5110,61 | 46,38 |
| 3 | 11,2104 | 7,89303 | 449,45 | 4,08 |
| 4 | 15,2895 | 5,79519 | 2041,10 | 18,53 |
| 5 | 15,5483 | 5,69932 | 2969,46 | 26,95 |
| 6 | 16,5322 | 5,36226 | 3896,54 | 35,37 |
| 7 | 17,1488 | 5,17082 | 5031,51 | 45,67 |
| 8 | 18,6959 | 4,74627 | 9858,93 | 89,48 |
| 9 | 20,3468 | 4,36475 | 7510,12 | 68,16 |
| 10 | 23,2127 | 3,83195 | 4836,88 | 43,90 |
| 11 | 23,8974 | 3,72368 | 6052,54 | 54,93 |
| 12 | 24,8727 | 3,57984 | 2513,84 | 22,82 |
| 13 | 26,3954 | 3,37669 | 11017,87 | 100,00 |
| 14 | 27,3200 | 3,26447 | 8607,53 | 78,12 |
| 15 | 28,4256 | 3,13997 | 1395,94 | 12,67 |
| 16 | 30,2248 | 2,95703 | 3236,77 | 29,38 |
| 17 | 30,4275 | 2,93779 | 3390,06 | 30,77 |
| 18 | 32,2293 | 2,77754 | 2545,04 | 23,10 |
| 19 | 34,5339 | 2,59728 | 1302,65 | 11,82 |
| 20 | 36,4324 | 2,46618 | 3206,25 | 29,10 |
| 21 | 37,5208 | 2,39512 | 4007,95 | 36,38 |
| 22 | 37,6732 | 2,38776 | 5514,17 | 50,05 |
| 23 | 38,8699 | 2,31696 | 334,53 | 3,04 |
| 24 | 39,7923 | 2,26535 | 768,98 | 6,98 |

**Tabelle 4: Probe 4: 10 g Pigment D (50 Mol-% Zink / 50 Mol-% Nickel) erfindungsgemäß**

| **Nr.** | **Pos. [°2Th.]** | **d [Å]** | **Int. [cts]** | **Rel. Int. [%]** |
|---|---|---|---|---|
| 1 | 8,5583 | 10,33202 | 14205,33 | 95,11 |
| 2 | 9,2650 | 9,54547 | 7410,93 | 49,62 |
| 3 | 11,8732 | 7,45388 | 396,41 | 2,65 |
| 4 | 15,7248 | 5,63572 | 3924,66 | 26,28 |
| 5 | 16,5543 | 5,35515 | 4966,76 | 33,25 |
| 6 | 17,0654 | 5,19592 | 7290,50 | 48,81 |
| 7 | 18,6670 | 4,75356 | 14936,10 | 100,00 |
| 8 | 19,1522 | 4,63422 | 4782,57 | 32,02 |
| 9 | 19,8789 | 4,46642 | 5704,31 | 38,19 |
| 10 | 20,2236 | 4,39105 | 11829,90 | 79,20 |
| 11 | 23,2723 | 3,82227 | 8493,82 | 56,87 |
| 12 | 24,0296 | 3,70349 | 5408,77 | 36,21 |
| 13 | 24,8719 | 3,57996 | 4108,57 | 27,51 |
| 14 | 26,4122 | 3,37457 | 14682,98 | 98,31 |
| 15 | 27,2517 | 3,27250 | 13145,84 | 88,01 |
| 16 | 28,4856 | 3,13349 | 1412,89 | 9,46 |
| 17 | 30,0794 | 2,97099 | 3555,63 | 23,81 |
| 18 | 30,4815 | 2,93271 | 4548,19 | 30,45 |
| 19 | 31,6862 | 2,82391 | 3789,55 | 25,37 |
| 20 | 32,1567 | 2,78365 | 3161,73 | 21,17 |
| 21 | 34,6478 | 2,58901 | 2429,89 | 16,27 |
| 22 | 35,8151 | 2,50726 | 1794,88 | 12,02 |
| 23 | 36,3090 | 2,47428 | 4576,23 | 30,64 |
| 24 | 37,5392 | 2,39597 | 6342,19 | 42,46 |
| 25 | 38,2636 | 2,35226 | 1300,43 | 8,71 |
| 26 | 38,8683 | 2,31705 | 495,46 | 3,32 |
| 27 | 39,4974 | 2,27970 | 1467,31 | 9,82 |
| 28 | 39,6359 | 2,27393 | 2202,84 | 14,75 |

**Tabelle 5: Probe 5: 10 g Pigment E (75 Mol-% Zink / 25 Mol-% Nickel) erfindungsgemäß**

| **Nr.** | **Pos. [°2Th.]** | **d [Å]** | **Int. [cts]** | **Rel. Int. [%]** |
|---|---|---|---|---|
| 1 | 8,5997 | 10,28242 | 17439,16 | 84,72 |
| 2 | 9,3269 | 9,48227 | 10905,46 | 52,98 |
| 3 | 11,9567 | 7,40202 | 607,58 | 2,95 |
| 4 | 15,4091 | 5,75046 | 4709,94 | 22,88 |
| 5 | 15,7436 | 5,62906 | 4361,38 | 21,19 |
| 6 | 16,5923 | 5,34299 | 6443,75 | 31,31 |
| 7 | 17,1491 | 5,17074 | 1666,94 | 51,82 |
| 8 | 17,8032 | 4,98220 | 2102,48 | 10,21 |
| 9 | 18,7116 | 4,74232 | 20583,65 | 100,00 |
| 10 | 19,1644 | 4,63131 | 6250,10 | 30,36 |
| 11 | 19,8394 | 4,47523 | 6459,78 | 31,38 |
| 12 | 20,1984 | 4,39648 | 16143,92 | 78,43 |
| 13 | 23,2351 | 3,82831 | 13401,31 | 65,11 |
| 14 | 23,6492 | 3,76220 | 9591,56 | 46,60 |
| 15 | 24,0145 | 3,70580 | 7022,98 | 34,12 |
| 16 | 24,8665 | 3,58072 | 5675,70 | 27,57 |
| 17 | 25,3404 | 3,51482 | 2759,72 | 13,41 |
| 18 | 26,4625 | 3,36827 | 18636,12 | 90,54 |
| 19 | 27,3170 | 3,26482 | 18179,60 | 88,32 |
| 20 | 28,1857 | 3,16614 | 2784,33 | 13,53 |
| 21 | 30,0457 | 2,97424 | 3887,21 | 18,88 |
| 22 | 30,5156 | 2,92951 | 5793,01 | 28,14 |
| 23 | 31,1461 | 2,87163 | 2845,72 | 13,83 |
| 24 | 31,7069 | 2,82211 | 5876,87 | 28,55 |
| 25 | 32,1318 | 2,78575 | 3359,47 | 16,32 |
| 26 | 34,6450 | 2,58921 | 3678,44 | 17,87 |
| 27 | 36,2235 | 2,47993 | 5658,66 | 27,49 |
| 28 | 37,4969 | 2,39858 | 6393,26 | 31,06 |
| 29 | 38,1304 | 2,35822 | 1850,95 | 8,99 |
| 30 | 38,8146 | 2,31822 | 672,95 | 3,27 |
| 31 | 39,4769 | 2,28272 | 3292,00 | 15,99 |

**Tabelle 6: Probe 6: 2,5 g Pigment A und 7,5 g Pigment B (physikalische Mischung 25 Mol-% Zink und 75 Mol-% Nickel) nicht erfindungsgemäß**

| **Nr.** | **Pos. [°2Th.]** | **d [Å]** | **Int. [cts]** | **Rel. Int. [%]** |
|---|---|---|---|---|
| 1 | 6,2589 | 14,12187 | 583,11 | 5,14 |
| 2 | 8,5447 | 10,34848 | 8270,60 | 72,89 |
| 3 | 9,2672 | 9,54325 | 4712,85 | 41,54 |
| 4 | 10,5920 | 8,35245 | 569,78 | 5,02 |
| 5 | 15,4448 | 5,73725 | 2304,67 | 20,31 |
| 6 | 15,7629 | 5,62219 | 2918,60 | 25,72 |
| 7 | 16,5916 | 5,34321 | 3061,89 | 26,99 |
| 8 | 17,1067 | 5,18347 | 4307,63 | 37,96 |
| 9 | 18,6222 | 4,76489 | 7827,36 | 68,98 |
| 10 | 20,4178 | 4,34974 | 6673,87 | 58,82 |
| 11 | 23,3109 | 3,81603 | 4928,90 | 43,44 |
| 12 | 23,9491 | 3,71577 | 5049,74 | 44,50 |
| 13 | 24,8993 | 3,57608 | 2026,01 | 17,86 |
| 14 | 26,4393 | 3,37117 | 11004,12 | 96,98 |
| 15 | 27,2626 | 3,27121 | 11346,51 | 100,00 |
| 16 | 28,9857 | 3,08055 | 520,51 | 4,59 |
| 17 | 30,5963 | 2,92197 | 2087,68 | 18,40 |
| 18 | 31,3342 | 2,85482 | 1775,08 | 15,64 |
| 19 | 32,3696 | 2,76583 | 1928,02 | 16,99 |
| 20 | 34,7356 | 2,58267 | 1132,64 | 9,98 |
| 21 | 35,7490 | 2,51174 | 864,78 | 7,62 |
| 22 | 36,0372 | 2,49231 | 1168,80 | 10,30 |
| 23 | 36,6646 | 2,45109 | 2435,23 | 21,46 |
| 24 | 37,8164 | 2,37905 | 4520,57 | 39,84 |
| 25 | 38,9036 | 2,31503 | 500,48 | 4,41 |
| 26 | 39,7636 | 2,26692 | 387,54 | 3,42 |

**Tabelle 7: Probe 7: 5,0 g Pigment A und 5,0 g Pigment B (physikalische Mischung 50 Mol-% Zink und 50 Mol-% Nickel) nicht erfindungsgemäß**

| **Nr.** | **Pos. [°2Th.]** | **d [Å]** | **Int. [cts]** | **Rel. Int. [%]** |
|---|---|---|---|---|
| 1 | 6,3554 | 13,90762 | 1332,81 | 11,21 |
| 2 | 8,6079 | 10,27265 | 4854,06 | 40,82 |
| 3 | 9,2074 | 9,60514 | 3022,44 | 25,42 |
| 4 | 10,6297 | 8,32291 | 968,83 | 8,15 |
| 5 | 14,2884 | 6,19891 | 498,12 | 4,19 |
| 6 | 15,7123 | 5,64018 | 2012,37 | 16,92 |
| 7 | 16,4890 | 5,37622 | 2234,67 | 18,79 |
| 8 | 17,1513 | 5,17007 | 2910,07 | 24,47 |
| 9 | 18,6611 | 4,75506 | 5185,80 | 43,61 |
| 10 | 20,3555 | 4,36290 | 5194,34 | 43,68 |
| 11 | 21,3948 | 4,15327 | 403,41 | 3,39 |
| 12 | 23,2904 | 3,81935 | 3104,21 | 26,11 |
| 13 | 24,0601 | 3,69888 | 2427,07 | 20,41 |
| 14 | 25,0058 | 3,56110 | 1575,41 | 13,25 |
| 15 | 26,3981 | 3,37635 | 10031,36 | 84,36 |
| 16 | 27,3159 | 3,26495 | 11890,57 | 100,00 |
| 17 | 29,0285 | 3,07611 | 1009,90 | 8,49 |
| 18 | 30,5702 | 2,92441 | 1329,14 | 11,18 |
| 19 | 31,4244 | 2,84683 | 1462,06 | 12,30 |
| 20 | 32,2851 | 2,77288 | 1669,50 | 14,04 |
| 21 | 34,5711 | 2,59458 | 810,73 | 6,82 |
| 22 | 35,9880 | 2,49561 | 1238,27 | 10,41 |
| 23 | 36,6030 | 2,45508 | 2054,04 | 17,27 |
| 24 | 37,8154 | 2,37911 | 3203,32 | 26,94 |
| 25 | 38,9622 | 2,31168 | 406,97 | 3,42 |

**Tabelle 8: Probe 8: 7,5 g Pigment A und 2,5 g Pigment B (physikalische Mischung 75 Mol-% Zink und 25 Mol-% Nickel) nicht erfindungsgemäß**

| **Nr.** | **Pos. [°2Th.]** | **d [Å]** | **Int.[cts]** | **Rel. Int. [%]** |
|---|---|---|---|---|
| 1 | 6,3215 | 13,98199 | 2052,53 | 16,93 |
| 2 | 8,5164 | 10,38277 | 2318,30 | 19,12 |
| 3 | 9,2296 | 9,58204 | 1348,65 | 11,12 |
| 4 | 10,4417 | 8,47234 | 1740,81 | 14,36 |
| 5 | 14,2608 | 6,21084 | 761,33 | 6,28 |
| 6 | 15,5542 | 5,69717 | 1125,12 | 9,28 |
| 7 | 16,4001 | 5,40516 | 1773,71 | 14,63 |
| 8 | 17,1125 | 5,18172 | 1973,02 | 16,27 |
| 9 | 17,7794 | 4,98883 | 659,31 | 5,44 |
| 10 | 18,7051 | 4,74397 | 2778,14 | 22,91 |
| 11 | 20,4031 | 4,35284 | 3133,33 | 25,84 |
| 12 | 21,1058 | 4,20947 | 1408,51 | 11,62 |
| 13 | 23,2661 | 3,82327 | 1358,95 | 11,21 |
| 14 | 23,9364 | 3,71771 | 1596,72 | 13,17 |
| 15 | 24,9618 | 3,56727 | 729,77 | 6,02 |
| 16 | 26,4936 | 3,36440 | 10202,91 | 84,14 |
| 17 | 27,3656 | 3,25913 | 12125,45 | 100,00 |
| 18 | 29,1379 | 3,06481 | 1150,21 | 9,49 |
| 19 | 30,4587 | 2,93485 | 629,46 | 5,19 |
| 20 | 31,3787 | 2,85087 | 1038,02 | 8,56 |
| 21 | 32,3482 | 2,76761 | 1090,73 | 9,00 |
| 22 | 34,3427 | 2,61131 | 310,13 | 2,56 |
| 23 | 36,0003 | 2,49479 | 1056,93 | 8,72 |
| 24 | 36,6259 | 2,45360 | 1257,43 | 10,37 |
| 25 | 37,8218 | 2,37872 | 1793,53 | 14,79 |

In den Tabellen 1 bis 8 wurden in der ersten Spalte die gemessenen Reflexe durchnummeriert. In Spalte 2 erfolgte die Angabe der Position der gemessenen Reflexe als 2Theta-Werte, in Spalte 3 wurden die ermittelten 2Theta-Werte mittels der Braggschen Gleichung in d-Werte für die Gitterkonstanten umgerechnet. In der vierten und fünften Spalte finden sich die Werte für die gemessenen Intensitäten (Peakhöhe der Reflexe über dem Untergrund) zum einen als absolute Werte in der Einheit "counts" [cts] sowie in ihrer relativen Intensität in Prozent.

Die Auswertung der röntgendiffraktometrischen Messungen der Tabellen 1 bis 8 zeigt, dass die erfindungsgemäßen Metallazopigmente C, D und E der Proben 3, 4 und 5 im Röntgendiffraktogramm bei einer Gitterkonstanten von d = 10,3 ( ± 0,2) Å jeweils ein Signal S₁ mit einer Intensität I₁ aufweisen. Im Gitterkonstantenbereich von d = 16,05 Å bis d = 11,78 Å hingegen weisen die Metallazopigmente der Proben 3, 4 und 5 kein Signal S₂ auf, dessen Intensität I₂ das Dreifache der Quadratwurzel des Untergrundes überschreitet. Per Definition ist ein gemessener Reflex erst dann als tatsächlicher Peak zu werten, wenn dessen Intensität größer ist als 3 σ (sigma), wobei der Wert σ festgelegt ist als die Quadratwurzel aus dem Wert für den Untergrund. Der Wert für den Untergrund ergibt sich aus der Anzahl der am Beginn des Diffraktogramms gemessenen counts. Bei dem verwendeten Diffraktometer liegt der Untergrund des Diffraktogramms bei ca. 4100 counts, so wird ein Peak erst ab ca. 200 counts (3- facher Wert über σ = 192,09, mit σ = Quadratwurzel aus 4100 counts = 64,03) nachweisbar. Die in den Tabellen 1 bis 8 angegebenen Intensitätswerte sind untergrundkorrigiert. D.h. der Wert für den Untergrund (bei dem hier verwendeten Gerät von 4100 counts) wurde jeweils von allen gemessenen Intensitätswerten rechnerisch subtrahiert. Für die Proben 3, 4 und 5 der erfindungsgemäßen Metallazopigmente C, D und E ergibt sich damit jeweils ein Verhältnis der Intensität I₁ der bei d = 10,3 ( ± 0,2) Å gemessenen Signale S₁ zum kleinsten (mit dem verwendeten Diffraktometer) im Intervall von d =16,05 Å bis d = 11,78 Å theoretisch nachweisbaren Intensitätswert I₂ von ca. 200 counts (nach Untergrundkorrektur), ausgedrückt als Quotient I₂/I₁, das den Wert 0,02 nicht überschreitet. Dies ist aus Tabelle 9 ersichtlich.

Da für die Proben 3, 4 und 5 keine Reflexe größer d = 10,3 ( ± 0,2) Å gemessen wurden, weisen die Tabellen 3, 4 und 5 in diesem Bereich keine Werte aus.

Ebenfalls ersichtlich ist, dass die nicht erfindungsgemäßen physikalischen Pigmentmischungen der Proben 6, 7 und 8 im Röntgendiffraktogramm bei einer Gitterkonstanten von d = 10,3 ( ± 0,2) Å jeweils ein Signal S₁ mit einer Intensität I₁ aufweisen und im Gitterkonstantenbereich von d = 16,05 Å bis d = 11,78 Å jeweils Signale S₂ aufweisen, deren Intensitäten I₂ jeweils im Verhältnis zur Intensität I₁ von Signal S₁, ausgedrückt als Quotient I₂/I₁, den Wert 0,02 überschreiten.

**Tabelle 9**

| **Probe** | **Pigment** | **I₁ [cts] von S₁ bei d= 10,3 ± 0,2) Å** | **I₂ [cts] von S₂ bei d= 11,78 bis 16,05 Å** | **I₂/I₁** | **Erfindungsgemäß** |
|---|---|---|---|---|---|
| **3:** | 10 g Pigment C | 10820 | 200 * | 0,0185 | ja |
| **4:** | 10 g Pigment D | 14205 | 200 * | 0,0140 | ja |
| **5:** | 10 g Pigment E | 17439 | 200 * | 0,0115 | ja |
| **6:** | 2,5 g Pigment A | 8270 | 583 | **0,0704** | nein |
| | 7,5 g Pigment B | | | | |
| **7:** | 5,0 g Pigment A | 4854 | 1332 | **0,2744** | nein |
| | 5,3 g Pigment B | | | | |
| **8:** | 6,0 g Pigment A | 2318 | 2052 | **0,8852** | nein |
| | 4,0 g Pigment B | | | | |

| | | | | | |
|---|---|---|---|---|---|
| *** 200 counts entsprechen dem theoretisch nachweisbaren Intensitätswert des verwendeten Diffraktometers** | | | | | |

### Anwendungstechnische Prüfung

Aus den nach den Synthesebeispielen 1 bis 5 hergestellten Pigmenten wurden wie oben angegeben die Proben 1 bis 8 zusammengestellt. Anschließend wurden die Proben nach Vorschrift 2 zu den entsprechenden Dispersionen umgesetzt wurden. Die Dispersionen 1 bis 8 wurden nach Vorschrift 3 umgesetzt und anwendungstechnisch geprüft. Die Ergebnisse in Form der Y-Werte sind in Tabelle 2 dargestellt.

### Vorschrift 2:

Ca. 2g von einer Mischung aus 2 Teile der zu prüfenden Pigmentprobe mit 2 Teilen Weichmacher (BASF Hexamoll® Dinch), 1 Teil Dispergieradditiv (Byk Bykoplast® 1000) und 1 Teil Dispergieradditiv (Lubrizol® Solsperse 10000) wurden auf einer Farbenausreibemaschine (Typ Auto muller) 4 x mit 75 Umdrehungen ausgerieben.

### Vorschrift 3:

0,750 g der jeweiligen Dispersion wurden auf 1000g Polystyrol-Granulat durch kräftiges Schütteln in einem PE-Beutel gleichmäßig verteilt. Das angefärbte Granulat wurde auf einem Doppelwellenextruder bei 500 U/min und Massetemperatur 200°C extrudiert und anschließend wieder granuliert. Außerdem wurde eine Probe ohne Pigment, aber mit gleichen Mengen von Additiv und Weichmacher benetztem, Polystyrol-Granulat wie oben. extrudiert und granuliert.

Von dem trockenen Granulat wurden auf einer Spritzgießmaschine mit 240 °C Massetemperatur, 10 bar Staudruck und 60 °C Formtemperatur Prüfplättchen mit 1mm, 2mm und 3mm Schichtdickenabstufung hergestellt. Mit einem Spektralphotometer wurde die Transmission der 1mm, 2mm und 3mm Stufe gemessen. Dabei wurde der Spektralphotometer mit Hilfe des farblosen Prüfplättchen bei jeweils 1,2 und 3mm kalibriert.

Die CIE Yxy Werte bei Lichtart D65 und 10° Beobachterwinkel werden für jede Schichtdicke berechnet und CIE Y zu Bezugswert CIE x = 0,435 durch Interpolation ermittelt.

**Tabelle 10**

| **Probe** | **Pigment** | | **Dispersion** | **Y-Wert (x = 0,435)** | **Erfindungsgemäß** |
|---|---|---|---|---|---|
| **1:** | 10 g Pigment B | | 1 | 85,4 | nein |
| **2:** | 10 g Pigment A | | 2 | 80,3 | nein |
| **3:** | 10 g Pigment C | | 3 | 88,2 | ja |
| **4:** | 10 g Pigment D | | 4 | 86,6 | ja |
| **5:** | 10 g Pigment E | | 5 | 86,1 | ja |
| **6:** | 2,5 g Pigment A | | 6 | 85,3 | nein |
| | 7,5 g Pigment B | | | | |
| **7:** | 5,0 g Pigment A | | 7 | 85,5 | nein |
| | 5,3 g Pigment B | | | | |
| **8:** | 6,0 g Pigment A | | 8 | 83,1 | nein |
| | 4,0 g Pigment B | | | | |

Ergebnis: Wie aus Tabelle 10 ersichtlich ist zeigen die erfindungsgemäßen Proben 3 - 5 erhöhte Y-Werte (bei konstantem x-Wert) im Vergleich zu den nicht- erfindungsgemäßen Proben und zeichnen sich deshalb durch eine erhöhte Helligkeit aus.

## Patentansprüche

1. Metallazopigmente enthaltend das Addukt aus
a) mindestens zwei Metallazoverbindungen der Formel (I) oder deren tautomeren Formen 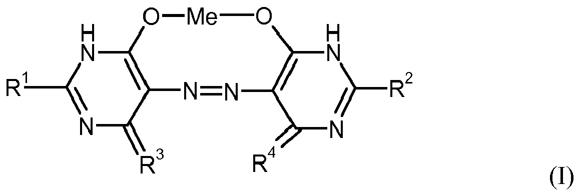 worin
R¹ und R² unabhängig voneinander für OH, NH₂ oder NHR⁵ stehen,
R³ und R⁴ unabhängig voneinander für =O oder =NR⁵ stehen,
R⁵ für Wasserstoff oder Alkyl steht, und
Me für ein 2- oder 3-wertiges Metallion ausgewählt aus der Reihe Ni²⁺, Zn²⁺, Cu²⁺, Al³⁺_{2/3}, Fe²⁺, Fe³⁺_{2/3}, Co²⁺ und Co³⁺_{2/3} steht,
mit der Maßgabe, dass die Menge an Metallionen aus der Reihe Zn²⁺ und Ni²⁺ 95 bis 100 Mol-% beträgt und die Menge an Metallionen ausgewählt aus der Reihe Cu²⁺, Al³⁺_{2/3}, Fe²⁺, Fe³⁺_{2/3}, Co²⁺ und Co³⁺_{2/3} 0 bis 5 Mol-% beträgt, jeweils bezogen auf ein Mol aller Verbindungen der Formel (I), und
wobei das Molverhältnis von Zn- zu Ni- Metallionen in der Summe der Verbindungen der Formel (I) 9 : 1 bis 1 : 9 beträgt,
und
b) mindestens einer Verbindung der Formel (II) 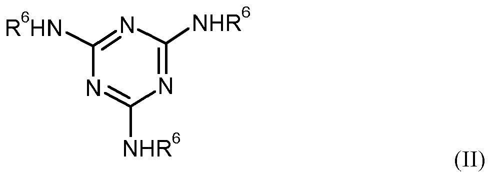 worin R⁶ für Wasserstoff oder Alkyl steht,
**dadurch gekennzeichnet, dass** das Metallazopigment im Röntgendiffraktogramm bei einer Gitterkonstanten von d = 10,3 ( ± 0,2) Å ein Signal S₁ mit einer Intensität I₁ aufweist und im Gitterkonstantenbereich von d = 16,05 Å bis d = 11,78 Å kein Signal S₂ aufweist dessen Intensität I₂ im Verhältnis zur Intensität I₁ von Signal S₁, ausgedrückt als Quotient I₂/I₁ der untergrundkorrigierten Intensitäten, den Wert 0,02 überschreitet.

2. Metallazopigmente gemäß Anspruch 1 enthaltend das Addukt aus
a) mindestens zwei Metallazoverbindungen der Formel (I) oder deren tautomeren Formen 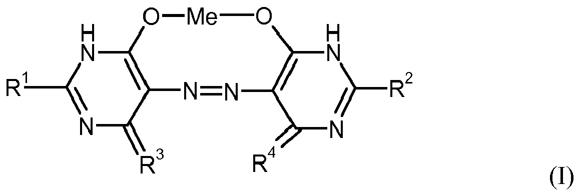 worin
R¹ und R² unabhängig voneinander für OH, NH₂ oder NHR⁵ stehen,
R³ und R⁴ unabhängig voneinander für =O oder =NR⁵ stehen,
R⁵ für Wasserstoff oder C₁-C₄-Alkyl steht, und
Me für ein 2- oder 3-wertiges Metallion ausgewählt aus der Reihe Ni²⁺, Zn²⁺, Cu²⁺, Al³⁺_{2/3}, Fe²⁺, Fe³⁺_{2/3}, Co²⁺ und Co³⁺_{2/3} steht,
mit der Maßgabe, dass die Menge an Metallionen aus der Reihe Zn²⁺ und Ni²⁺ 95 bis 100 Mol-% beträgt und die Menge an Metallionen ausgewählt aus der Reihe Cu²⁺, Al³⁺_{2/3}, Fe²⁺, Fe³⁺_{2/3}, Co²⁺ und Co³⁺_{2/3} 0 bis 5 Mol-% beträgt, jeweils bezogen auf ein Mol aller Verbindungen der Formel (I), und
wobei das Molverhältnis von Zn- zu Ni- Metallionen in der Summe der Verbindungen der Formel (I) 9 : 1 bis 1 : 9 beträgt,
und
b) mindestens einer Verbindung der Formel (II) 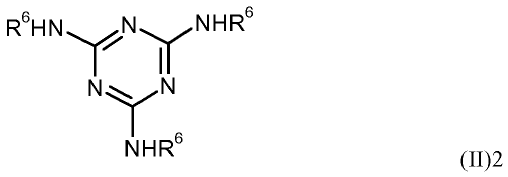 worin
R⁶ für Wasserstoff oder C₁-C₄-Alkyl steht, das gegebenenfalls mit einer oder
mehreren OH-Gruppen substituiert ist,
**dadurch gekennzeichnet, dass** das Metallazopigment im Röntgendiffraktogramm bei einer Gitterkonstanten von d = 10,3 ( ± 0,2) Å ein Signal S₁ mit einer Intensität I₁ aufweist und im Gitterkonstantenbereich von d = 16,05 Å bis d = 11,78 Å kein Signal S₂ aufweist dessen Intensität I₂ im Verhältnis zur Intensität I₁ von Signal S₁, ausgedrückt als Quotient I₂/I₁ der untergrundkorrigierten Intensitäten, den Wert 0,02 überschreitet.

3. Metallazopigmente gemäß Anspruch 1 und 2 enthaltend das Addukt aus
a) einer Metallazoverbindung der Formel (Ia) oder einer ihrer tautomeren Formen 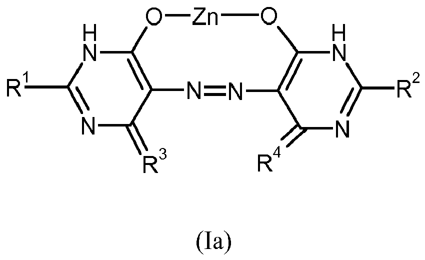 worin
R¹ und R² unabhängig voneinander für OH, NH₂ oder NHR⁵ stehen,
R³ und R⁴ unabhängig voneinander für =O oder =NR⁵ stehen,
R⁵ für Wasserstoff oder C₁-C₄-Alkyl steht, und
einer Metallazoverbindung der Formel (Ib) oder einer ihrer tautomeren Formen 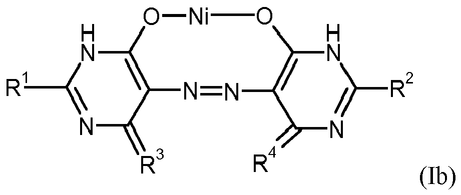 worin
R¹ und R² unabhängig voneinander für OH, NH₂ oder NHR⁵ stehen,
R³ und R⁴ unabhängig voneinander für =O oder =NR⁵ stehen, und
R⁵ für Wasserstoff oder C₁-C₄-Alkyl steht, und
gegebenenfalls einer Verbindung der Formel (Ic) 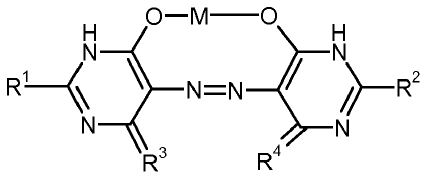 worin
R¹ und R² unabhängig voneinander für OH, NH₂ oder NHR⁵ stehen,
R³ und R⁴ unabhängig voneinander für =O oder =NR⁵ stehen, und
R⁵ für Wasserstoff oder C₁-C₄-Alkyl* steht, und
M für ein 2- oder 3-wertiges Metallion ausgewählt aus der Reihe Cu²⁺, Al³⁺_{2/3}, Fe²⁺, Fe³⁺_{2/3}, Co²⁺ und Co³⁺_{2/3} steht,
mit der Maßgabe, dass die Menge an Metallionen aus der Reihe Zn²⁺ und Ni²⁺ 95 bis 100 Mol-% beträgt, und die Menge an Metallionen ausgewählt aus der Reihe Cu²⁺, Al³⁺_{2/3}, Fe²⁺, Fe³⁺_{2/3}, Co²⁺ und Co³⁺_{2/3} 0 bis 5 Mol-% beträgt, jeweils bezogen auf ein Mol aller Verbindungen der Formel (I),
wobei das Molverhältnis von Zn- zu Ni- Metallionen in der Summe der Verbindungen der Formeln (Ia) und (Ib) 9 : 1 bis 1 : 9 beträgt,
und
b) mindestens einer Verbindung der Formel (II) 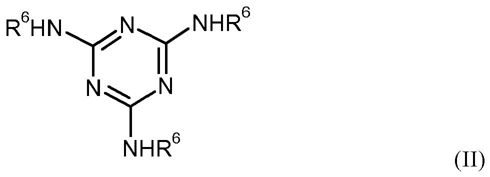 worin
R⁶ für Wasserstoff oder C₁-C₄-Alkyl steht, das gegebenenfalls mit einer oder mehreren OH-Gruppen substituiert ist,
**dadurch gekennzeichnet, dass** das Metallazopigment im Röntgendiffraktogramm bei einer Gitterkonstanten von d = 10,3 ( ± 0,2) Å ein Signal S₁ mit einer Intensität I₁ aufweist und im Gitterkonstantenbereich von d = 16,05 Å bis d = 11,78 Å kein Signal S₂ aufweist dessen Intensität I₂ im Verhältnis zur Intensität I₁ von Signal S₁, ausgedrückt als Quotient I₂/I₁ der untergrundkorrigierten Intensitäten, den Wert 0,02 überschreitet.

4. Metallazopigmente gemäß wenigstens einem der Ansprüche 1 bis 3 enthaltend das Addukt aus
a) einer Metallazoverbindung der Formel (Ia) oder einer ihrer tautomeren Formen 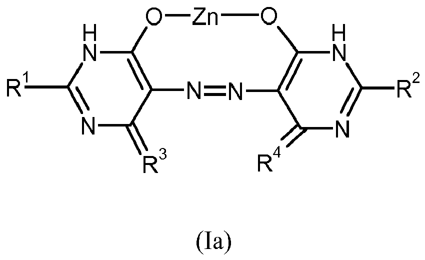 worin
R¹ und R² unabhängig voneinander für OH, NH₂ oder NHR⁵ stehen,
R³ und R⁴ unabhängig voneinander für =O oder =NR⁵ stehen,
R⁵ für Wasserstoff oder C₁-C₄-Alkyl steht, und
einer Metallazoverbindung der Formel (Ib) oder einer ihrer tautomeren Formen 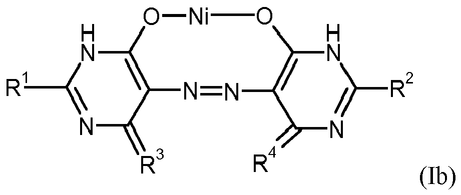 worin
R¹ und R² unabhängig voneinander für OH, NH₂ oder NHR⁵ stehen,
R³ und R⁴ unabhängig voneinander für =O oder =NR⁵ stehen, und
R⁵ für Wasserstoff oder C₁-C₄-Alkyl steht, und
mit der Maßgabe, dass die Menge an Metallionen aus der Reihe Zn²⁺ und Ni²⁺ 100 Mol-% beträgt, bezogen auf ein Mol aller Verbindungen (Ia) und (Ib),
wobei das Molverhältnis von Zn- zu Ni- Metallionen in der Summe der Verbindungen der Formeln (Ia) und (Ib) 9 : 1 bis 1 : 9 beträgt,
und
b) mindestens einer Verbindung der Formel (II) 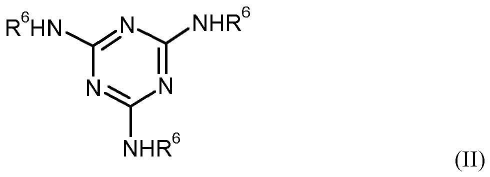 worin
R⁶ für Wasserstoff oder C₁-C₄-Alkyl steht, das gegebenenfalls mit einer oder mehreren OH-Gruppen substituiert ist,
**dadurch gekennzeichnet, dass** das Metallazopigment im Röntgendiffraktogramm bei einer Gitterkonstanten von d = 10,3 ( ± 0,2) Å ein Signal S₁ mit einer Intensität I₁ aufweist und im Gitterkonstantenbereich von d = 16,05 Å bis d = 11,78 Å kein Signal S₂ aufweist dessen Intensität I₂ im Verhältnis zur Intensität I₁ von Signal S₁, ausgedrückt als Quotient I₂/I₁ der untergrundkorrigierten Intensitäten, den Wert 0,02 überschreitet.

5. Metallazopigmente gemäß wenigstens einem der Ansprüche 1 bis 4 enthaltend das Addukt aus
a) einer Metallazoverbindung der Formel (Ia) oder einer ihrer tautomeren Formen 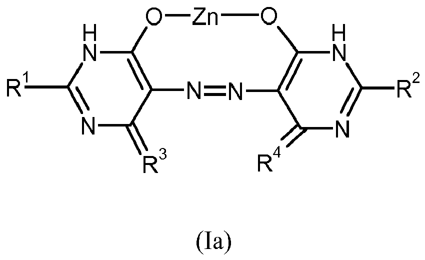 worin
R¹ und R² für OH stehen,
R³ und R⁴ für =O stehen,
und
einer Metallazoverbindung der Formel (Ib) oder einer ihrer tautomeren Formen 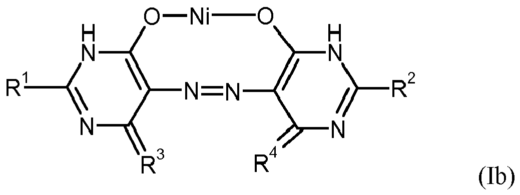 worin
R¹ und R² für OH stehen,
R³ und R⁴ für =O stehen,
mit der Maßgabe, dass die Menge an Metallionen aus der Reihe Zn und Ni 100 Mol-% beträgt, bezogen auf ein Mol an Verbindungen (Ia) und (Ib),
wobei das Molverhältnis von Zn- zu Ni- Metallionen in der Summe der Verbindungen der Formeln (Ia) und (Ib) 9 : 1 bis 1 : 9 beträgt,
und
b) mindestens einer Verbindung der Formel (II) 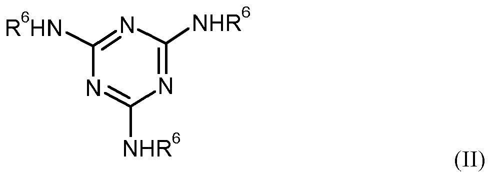 worin
R⁶ für Wasserstoff steht,
**dadurch gekennzeichnet, dass** das Metallazopigment im Röntgendiffraktogramm bei einer Gitterkonstanten von d = 10,3 ( ± 0,2) Å ein Signal S₁ mit einer Intensität I₁ aufweist und im Gitterkonstantenbereich von d = 16,05 Å bis d = 11,78 Å kein Signal S₂ aufweist dessen Intensität I₂ im Verhältnis zur Intensität I₁ von Signal S₁, ausgedrückt als Quotient I₂/I₁ der untergrundkorrigierten Intensitäten, den Wert 0,02 überschreitet.

6. Pigmentpräparation enthaltend wenigstens ein Metallazopigment gemäß wenigstens einem der Ansprüche 1 bis 5.

7. Pigmentpräparation gemäß Anspruch 6, **dadurch gekennzeichnet, dass** sie wenigstens ein Dispergiermittel enthält.

8. Pigmentpräparation gemäß wenigstens einem der Ansprüche 6 und 7, **dadurch gekennzeichnet, dass** sie C.I. Pigment Green 36 und/oder C.I. Pigment Green 58 enthält.

9. Pigmentpräparation gemäß wenigstens einem der Ansprüche 6 bis 8, **dadurch gekennzeichnet, dass** sie als weitere Komponente d) wenigstens eine organische Verbindung ausgewählt aus der Gruppe der Terpene, Terpenoide, Fettsäureester und der Gruppe der Homo- oder Copolymere, wie statistische- oder Block-Copolymere, mit einer Löslichkeit in Wasser bei 20°C von weniger als 1 g/l, insbesondere weniger als 0,1 g/l enthält.

10. Verfahren zur Herstellung eines Metallazopigments gemäß wenigstens einem der Ansprüche 1 bis 5, **dadurch gekennzeichnet, dass** man eine Verbindung der Formel (Id), oder deren Tautomere, 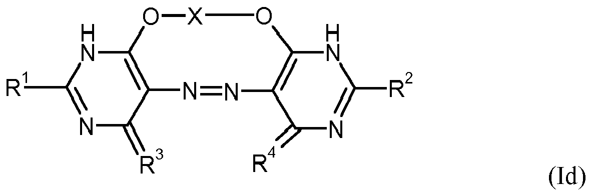 worin
X für ein Alkalimetallion, vorzugsweise für ein Natrium- oder Kaliumion steht,
und R¹, R², R³, R⁴ und R⁵ die in Anspruch 1 angegebene Bedeutung haben,
mit mindestens einer Verbindung der Formel (II) 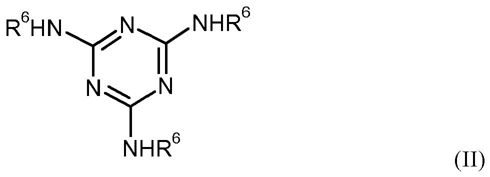 worin R⁶ die in Anspruch 1 angegebene Bedeutung hat,
und mit mindestens einem Nickelsalz und mit mindestens einem Zinksalz und gegebenenfalls mit mindestens einem weiteren Metallsalz aus der Reihe der Kupfer-, Aluminium-, Eisen- und Kobaltsalze umsetzt.

11. Metallazopigment erhältlich durch Umsetzung einer Verbindung der Formel (Id), oder deren Tautomere, 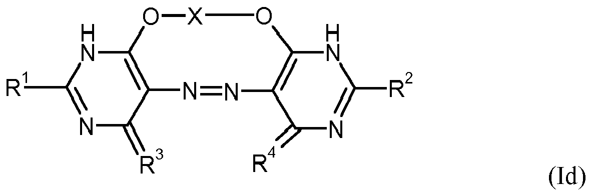 worin
X für ein Alkalimetallion, vorzugsweise für ein Natrium- oder Kaliumion steht, und
R¹, R², R³, R⁴ und R⁵ die in Anspruch 1 angegebene Bedeutung haben,
mit mindestens einer Verbindung der Formel (II) 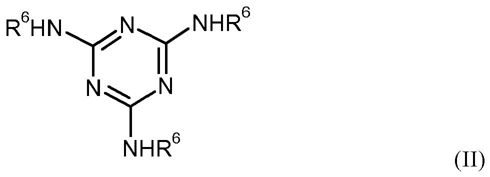 worin R⁶ die in Anspruch 1 angegebene Bedeutung hat,
und mit mindestens einem Nickelsalz und mit mindestens einem Zinksalz und gegebenenfalls mit mindestens einem weiteren Metallsalz aus der Reihe der Kupfer-, Aluminium-, Eisen- und Kobaltsalze.

12. Verfahren zur Herstellung einer Pigmentpräparation nach wenigstens einem der Ansprüche 6 bis 9, **dadurch gekennzeichnet, dass** man wenigstens ein Metallazopigment gemäß wenigstens einem der Ansprüche 1 bis 5 mit wenigstens einem Dispergiermittel und gegebenenfalls wenigstens einem weiteren Pigment und gegebenenfalls mit wenigstens einer organischen Verbindung ausgewählt aus der Gruppe der Terpene, Terpenoide, Fettsäureester und der Gruppe der Homo- oder Copolymere, vermischt und vermahlt.

13. Verwendung eines Metallazopigments gemäß wenigstens einem der Ansprüche 1 bis 5 zur Herstellung von Pigmentpräparationen.

14. Verwendung einer Pigmentpräparation gemäß wenigstens einem der Ansprüche 6 bis 9 zur Herstellung von Ink Jet Tinten, Farbfiltern für Flüssigkristallanzeigen, Druckfarben, Leimfarben oder Binderfarben, für die Massefärbung von synthetischen, halbsynthetischen oder natürlichen makromolekularen Stoffen, insbesondere Polyvinylchlorid, Polystyrol, Polyamid, Polyethylen oder Polypropylen, sowie für die Spinnfärbung von natürlichen, regenerierten oder künstlichen Fasern, wie z.B. Cellulose-, Polyester-, Polycarbonat-, Polyacrylnitril- oder Polyamidfasern, sowie zum Bedrucken von Textilien und Papier.

15. Farbfilter enthaltend wenigstens ein Metallazopigment gemäß wenigstens einem der Ansprüche 1 bis 5 oder eine Pigmentpräparation gemäß wenigstens einem der Ansprüche 6 bis 9.

16. Verwendung von Pigmentpräparationen gemäß wenigstens einem der Ansprüche 6 bis 9 zur Herstellung von Farbfiltern für Flüssigkristallanzeigen.

17. Photolack, enthaltend wenigstens ein photohärtbares Monomer, wenigstens einen Photoinitiator und wenigstens ein Metallazopigment gemäß wenigstens einem der Ansprüche 1 bis 5 oder eine Pigmentpräparation gemäß wenigstens einem der Ansprüche 6 bis 9.

18. Verfahren zur Herstellung von Farbfiltern für Flüssigkristallanzeigen, **dadurch gekennzeichnet, dass** wenigstens ein Metallazopigment gemäß wenigstens einem der Ansprüche 1 bis 5 oder eine Pigmentpräparation gemäß wenigstens einem der Ansprüche 6 bis 9, in einem organischen Lösungsmittel gegebenenfalls unter Zusatz eines Bindemittelharzes und/oder Dispergiermittels gemahlen wird, anschließend unter Zusatz von photohärtbaren Monomeren, Photoreaktionsstarter und gegebenenfalls weiterem Bindemittel und/oder Lösungsmittel zu einem Photolack verarbeitet wird, der im Anschluss daran mittels geeigneter Beschichtungsverfahren wie z.B. Roller-, Spray-, Spin-, Dip- oder Air-Knife-Coating auf ein geeignetes Substrat, im Allgemeinen Glasplatte aufgetragen wird, mittels Photomaske belichtet und anschließend gehärtet und zum fertigen farbigen Farbfilter entwickelt wird.

19. Flüssigkristallanzeige, enthaltend wenigstens einen Farbfilter gemäß Anspruch 15.

20. Verwendung von Pigmentpräparationen gemäß wenigstens einem der Ansprüche 6 bis 9, in Drucktinten zur Herstellung von Farbfiltern nach dem Verfahren der Photolithographie, Offset-Druck oder dem Verfahren des mechanischen, piezzo-mechanischen oder thermischen Ink Jet Drucks.

21. Verwendung gemäß Anspruch 20, **dadurch gekennzeichnet, dass** die Drucktinten zusätzlich ein wässrig-organisches Trägermedium enthalten.
